# EUROPÄISCHE PATENTANMELDUNG

(11) **EP 4 129 959 A1**
(43) Veröffentlichungstag der Anmeldung: **08.02.2023**
(21) Anmeldenummer: 21189486.0
(22) Anmeldetag: 03.08.2021
(51) Int. Cl.: C04B 41/89, C30B 25/02

(54) **VERFAHREN ZUR HERSTELLUNG VON BESCHICHTETEN SUBSTRATEN SOWIE BESCHICHTETES SUBSTRAT UND DESSEN VERWENDUNG**

(71) Anmelder: Fraunhofer-Gesellschaft zur Förderung der angewandten Forschung e.V., 80686 München (DE)
(72) Erfinder: Schuck, Kevin, 91058 Erlangen (DE); Reimann, Christian, 91058 Erlangen (DE); Lang, Michael, 91058 Erlangen (DE)
(74) Vertreter: Pfenning, Meinig & Partner mbB

(57) **Zusammenfassung**

Die vorliegende Erfindung betrifft ein Verfahren zur Herstellung von beschichteten Substraten, bei welchem eine erste wässrige Suspension und eine zweite wässrige Suspension hergestellt werden, mindestens eine Schicht der ersten wässrigen Suspension auf ein Substrat aufgebracht wird, mindestens eine Schicht der zweiten wässrigen Suspension auf der mindestens einen auf das Substrat aufgebrachten Schicht der ersten wässrigen Suspension aufgebracht wird und das so beschichtete Substrat einem Sinterprozess unterzogen wird. Die erste wässrige Suspension enthält mindestens ein Refraktärmetallcarbid, mindestens ein Sinteradditiv ausgewählt ist aus der Gruppe bestehend aus Silicium, Zirconiumborid, Refraktärmetallsiliciden sowie Mischungen hiervon, und Wasser oder besteht daraus. Die zweite wässrige Suspension enthält ebenfalls mindestens ein Refraktärmetallcarbid und Wasser. Zudem kann die zweite wässrige Suspension mindestens ein Sinteradditiv ausgewählt aus der Gruppe bestehend aus Silicium, Zirconiumborid, Refraktärmetallsiliciden sowie Mischungen hiervon enthalten, wobei der gewichtsprozentuale Anteil des mindestens einen Sinteradditivs in der zweiten wässrigen Suspension, bezogen auf das Gesamtgewicht der zweiten wässrigen Suspension, kleiner ist als der gewichtsprozentuale Anteil des mindestens einen Sinteradditivs in der ersten wässrigen Suspension, bezogen auf das Gesamtgewicht der ersten wässrigen Suspension. Alternativ kann die zweite wässrige Suspension auch kein Sinteradditiv enthalten. Die vorliegende Erfindung betrifft ferner ein beschichtetes Substrat, welches mit dem erfindungsgemäßen Verfahren hergestellt oder herstellbar sein kann, sowie die Verwendung eines solchen beschichteten Substrats.

## Beschreibung

Die vorliegende Erfindung betrifft ein Verfahren zur Herstellung von beschichteten Substraten, bei welchem eine erste wässrige Suspension und eine zweite wässrige Suspension hergestellt werden, mindestens eine Schicht der ersten wässrigen Suspension auf ein Substrat aufgebracht wird, mindestens eine Schicht der zweiten wässrigen Suspension auf der mindestens einen auf das Substrat aufgebrachten Schicht der ersten wässrigen Suspension aufgebracht wird und das so beschichtete Substrat einem Sinterprozess unterzogen wird. Die erste wässrige Suspension enthält mindestens ein Refraktärmetallcarbid, mindestens ein Sinteradditiv ausgewählt ist aus der Gruppe bestehend aus Silicium, Zirconiumborid, Refraktärmetallsiliciden sowie Mischungen hiervon, und Wasser oder besteht daraus. Die zweite wässrige Suspension enthält ebenfalls mindestens ein Refraktärmetallcarbid und Wasser. Zudem kann die zweite wässrige Suspension mindestens ein Sinteradditiv ausgewählt aus der Gruppe bestehend aus Silicium, Zirconiumborid, Refraktärmetallsiliciden sowie Mischungen hiervon enthalten, wobei der gewichtsprozentuale Anteil des mindestens einen Sinteradditivs in der zweiten wässrigen Suspension, bezogen auf das Gesamtgewicht der zweiten wässrigen Suspension, kleiner ist als der gewichtsprozentuale Anteil des mindestens einen Sinteradditivs in der ersten wässrigen Suspension, bezogen auf das Gesamtgewicht der ersten wässrigen Suspension. Alternativ kann die zweite wässrige Suspension auch kein Sinteradditiv enthalten. Die vorliegende Erfindung betrifft ferner ein beschichtetes Substrat, welches mit dem erfindungsgemäßen Verfahren hergestellt oder herstellbar sein kann, sowie die Verwendung eines solchen beschichteten Substrats.

Refraktärmetallcarbide wie beispielsweise Tantalcarbid (TaC) zeichnen sich im Allgemeinen durch ihre hohe mechanische, chemische und thermische Beständigkeit aus. Der Einsatz dieser Werkstoffe fokussiert sich v.a. auf Hochtemperaturanwendungen, z.B. in der Halbleiterkristallzüchtung, in denen stark korrosive und aggressive Spezies vorhanden sind und damit die Einsatzfähigkeit des bestehenden Bauteils (z.B. aus Graphit) eingeschränkt bzw. dessen Lebensdauer deutlich reduziert wird. Da es sich als schwierig gestaltet, mit Hilfe der aus der Literatur beschriebenen Prozesse zum Heißpressen ein bewährtes Volumenbauteil aus Refraktärmetallcarbiden kostengünstig und in komplexer Geometrie herzustellen, wird bevorzugt auf Beschichtungen zurückgegriffen. Die Herstellung von keramischen Schichten über das Heißpressen ist verfahrensbedingt nicht möglich. Beschichtungen werden beispielsweise über das CVD-Verfahren erzeugt. Dabei werden über die Gasphase dichte Schichten von wenigen Mikrometern auf ein Substrat abgeschieden. Ein Beispiel dazu wären TaC-Beschichtungen im Einlagenaufbau. Das kostenintensive Verfahren verwehrt allerdings, dass beschichtete Bauteile mit beliebigen Geometrien und Größen mit beliebiger Schichtdicke realisiert werden können. Um eine größere Flexibilität in diesen Bereichen zu gewährleisten, gibt es die Möglichkeit, die Schichten über ein nasskeramisches Verfahren (Tauchen, Pinseln oder Versprühen) auf das Substrat aufzutragen. Dies kann beispielsweise über eine Suspension auf Basis von organischen Lösungsmitteln erreicht werden (siehe z.B. US 2013/0061800 A1). Für die Erzeugung der gewünschten Schutzschichteigenschaften wird dem Auftragungsprozess über eine Ausgangssuspension ein Sinterprozess nachgeschaltet.

Neben der Erzeugung einer mechanisch stabilen Beschichtung durch den abschließenden Sinterprozess (hohe Abrieb- und Haftfestigkeit) wird gleichzeitig ein hoher Verdichtungsgrad gefordert, um das Substrat optimal vor korrosiven Medien in der Hochtemperaturanwendung zu schützen. Da es sich bei den Refraktärmetallcarbiden hauptsächlich um Verbindungen handelt, die stark kovalente Bindungen und eine sehr geringe Selbstdiffusion aufweisen, liegt eine erste Herausforderung in der Optimierung des Sintervorgangs für eine maximal mögliche Ausbeute des Verdichtungsgrads. Eine beliebte Methode zur Steigerung der Sinteraktivität, v.a. im Bereich des drucklosen Sinterns, ist der Einsatz von Sinterhilfsmitteln, die während des Sinterprozesses in eine flüssige Schmelzphase übergehen und es so zu einer bevorzugten Partikelumlagerung kommt (Flüssigphasensinterung). Dabei ist vorzugsweise darauf zu achten, dass das Sinterhilfsmittel eine stabile Schmelzphase unter den gegebenen Sinterbedingungen (Temperatur, Druck, etc.) bildet. Es kann auch von Vorteil sein, bei der Verwendung von ausgewählten Sinteradditiven, die Sinterbedingungen für ein ideales Sinterergebnis anzupassen, beispielsweise durch die Erhöhung des Anlagendrucks bei Inertgasatmosphäre.

Aus schon publizierten Arbeiten (siehe z.B. US 2013/0061800 A1) ist bekannt, dass die Verwendung von Übergangsmetallen als Sinteradditive, wie z.B. Cobalt, beim drucklosen Sintern von TaC-Beschichtungen zu einer Maximierung des Verdichtungsgrads führen können. Allerdings handelt es sich bei Cobalt um einen sehr toxischen Stoff, der ökologische, gesundheitliche und sicherheitstechnische Probleme für die suspensionsbasierte Beschichtungstechnologie bereitet. Weiterhin sind bei der Verwendung von Übergangsmetallen als Sinteradditive leicht entzündliche Pulvergemische möglich, die ebenfalls sicherheitstechnisch bedenklich sein können. Der Einsatz einer Refraktärmetallcarbid-basierten Schutzschicht in der Halbleiterkristallzüchtung gibt weiterhin vor, dass kritische Verunreinigungen, dazu gehören v.a. auch die aus der Literatur bekannten Übergangsmetalle Cobalt, Nickel, Eisen, etc., unter keinen Umständen aus dem Reaktorinnenaufbau, in dem die Beschichtung eingesetzt werden soll, in die Züchtungsatmosphäre gelangen darf.

Ausgehend hiervon war es die Aufgabe der vorliegenden Erfindung ein aus sicherheitstechnischer Sicht unbedenklicheres Verfahren zur Herstellung von beschichteten Substraten anzugeben, die besonders gut zur Verwendung in Hochtemperaturanwendungen, wie z.B. bei der Halbleiterkristallzüchtung, geeignet sind. Zudem war es die Aufgabe der vorliegenden Erfindung beschichte Substrate bereitzustellen, die auf aus sicherheitstechnischer Sicht unbedenklichere Weise herstellbar sind und besonders gut zur Verwendung in Hochtemperaturanwendungen, wie z.B. bei der Halbleiterkristallzüchtung, geeignet sind.

Diese Aufgabe wird bezüglich eines Verfahrens zur Herstellung von beschichteten Substraten mit den Merkmalen des Patentanspruchs 1 und bezüglich eines beschichteten Substrats mit den Merkmalen des Patentanspruchs 10 gelöst. In Patentanspruch 15 werden Verwendungsmöglichkeiten des erfindungsgemäßen beschichteten Substrats angegeben. Die abhängigen Patentansprüche stellen vorteilhafte Weiterbildungen dar.

Erfindungsgemäß wird somit ein Verfahren zur Herstellung von beschichteten Substraten angegeben, bei welchem
a) eine erste wässrige Suspension hergestellt wird, die mindestens ein Refraktärmetallcarbid, mindestens ein Sinteradditiv ausgewählt ist aus der Gruppe bestehend aus Silicium, Zirconiumborid, Refraktärmetallsiliciden sowie Mischungen hiervon, und Wasser enthält oder daraus besteht,
b) eine zweite wässrige Suspension hergestellt wird, die mindestens ein Refraktärmetallcarbid und Wasser enthält, wobei die zweite wässrige Suspension
   - mindestens ein Sinteradditiv ausgewählt aus der Gruppe bestehend aus Silicium, Zirconiumborid, Refraktärmetallsiliciden sowie Mischungen hiervon enthält, wobei der gewichtsprozentuale Anteil des mindestens einen Sinteradditivs in der zweiten wässrigen Suspension, bezogen auf das Gesamtgewicht der zweiten wässrigen Suspension, kleiner ist als der gewichtsprozentuale Anteil des mindestens einen Sinteradditivs in der ersten wässrigen Suspension, bezogen auf das Gesamtgewicht der ersten wässrigen Suspension, oder
   - kein Sinteradditiv enthält,
c) mindestens eine Schicht der ersten wässrigen Suspension auf ein Substrat aufgebracht wird,
d) mindestens eine Schicht der zweiten wässrigen Suspension auf der mindestens einen auf das Substrat aufgebrachten Schicht der ersten wässrigen Suspension aufgebracht wird, und
e) das (beschichtete) Substrat nach Schritt d) einem Sinterprozess unterzogen wird.

In Schritt a) des erfindungsgemäßen Verfahrens wird eine erste wässrige Suspension und in Schritt b) des erfindungsgemäßen Verfahrens wird eine zweite wässrige Suspension hergestellt. Schritt b) kann vor Schritt a), nach Schritt a) oder (zumindest teilweise) gleichzeitig mir Schritt a) durchgeführt werden. Die erste wässrige Suspension und/oder die zweite wässrige Suspension kann (jeweils) durch Vermischen der Komponenten, die in der jeweiligen Suspension enthalten sein sollen, hergestellt werden. Die erste wässrige Suspension und die zweite wässrige Suspension enthalten jeweils mindestens ein Refraktärmetallcarbid und Wasser. Bei dem mindestens einen in der ersten wässrigen Suspension enthaltenen Refraktärmetallcarbid und dem mindestens einen in der zweiten wässrigen Suspension enthaltenen Refraktärmetallcarbid kann es sich um das gleiche Refraktärmetallcarbid oder um verschiedene Refraktärmetallcarbide handeln. Zudem enthält die erste wässrige Suspension mindestens ein Sinteradditiv, welches ausgewählt ist aus der Gruppe bestehend aus Silicium, Zirconiumborid, Refraktärmetallsiliciden sowie Mischungen hiervon. Auch die zweite wässrige Suspension kann ein Sinteradditiv ausgewählt aus der Gruppe bestehend aus Silicium, Zirconiumborid, Refraktärmetallsiliciden sowie Mischungen hiervon enthalten, wobei dann der gewichtsprozentuale Anteil des mindestens einen Sinteradditivs in der zweiten wässrigen Suspension, bezogen auf das Gesamtgewicht der zweiten wässrigen Suspension, kleiner ist als der gewichtsprozentuale Anteil des mindestens einen Sinteradditivs in der ersten wässrigen Suspension, bezogen auf das Gesamtgewicht der ersten wässrigen Suspension. Alternativ kann die zweite wässrige Suspension auch kein Sinteradditiv enthalten. Beispielsweise kann die zweite wässrige Suspension kein Sinteradditiv ausgewählt aus der Gruppe bestehend aus Silicium; Zirconiumborid; Refraktärmetallsiliciden, beispielsweise TaSi₂, MoSi₂, ZrSi₂; Übergangsmetallen; Borcarbid (B₄C); Siliciumnitrid (Si₃N₄); Kohlenstoff; sowie Mischungen hiervon enthalten. Vorzugsweise besteht die zweite wässrige Suspension aus mindestens einem Refraktärmetallcarbid, Wasser, und optional mindestens einem Sinteradditiv ausgewählt aus der Gruppe bestehend aus Silicium, Zirconiumborid, Refraktärmetallsiliciden sowie Mischungen hiervon. Bei dem mindestens einen in der ersten wässrigen Suspension enthaltenen Sinteradditiv und dem mindestens einen in der zweiten wässrigen Suspension enthaltenen Sinteradditiv kann es sich um das gleiche Sinteradditiv oder um verschiedene Sinteradditive handeln.

Unter einem Sinteradditiv kann ein Stoff verstanden werden, der gezielt als Hilfsmittel für die Sinterung von keramischen Systemen zur Herstellung von keramischen Bauteilen hinzugegeben wird, um die mikrostrukturelle und räumliche Entwicklung (z.B. Schrumpfung, Kornwachstum, Formänderung und/oder Homogenisierung) zu steuern.

In Schritt c) des erfindungsgemäßen Verfahrens wird mindestens eine Schicht der ersten wässrigen Suspension auf ein Substrat aufgebracht. Bei dem Substrat kann es sich vorzugsweise um ein Kohlenstoff-Substrat, besonders bevorzugt um ein Graphit-Substrat, ganz besonders bevorzugt um ein iso-Graphit-Substrat, handeln. Unter iso-Graphit wird dabei Graphit verstanden, der nach dem Verfahren des isostatischen Pressens hergestellt wurde. Beispielsweise kann das Substrat ein Tiegel, vorzugsweise ein Kohlenstoff-Tiegel, besonders bevorzugt ein Graphit-Tiegel, ganz besonders bevorzugt ein iso-Graphit-Tiegel, sein. Das Aufbringen der mindestens einen Schicht der ersten wässrigen Suspension auf das Substrat kann beispielsweise mittels Tauchen, Pinseln, Sprühauftragung oder einer Kombination hiervon erfolgen. Beispielsweise kann mindestens eine Schicht der ersten wässrigen Suspension mit einer mittleren Schichtdicke von mindestens 20 µm, bevorzugt von 20 um bis 150 µm, besonders bevorzugt von 30 µm bis 100 µm, auf das Substrat aufgebracht werden.

In Schritt d) des erfindungsgemäßen Verfahrens wird mindestens eine Schicht der zweiten wässrigen Suspension auf der mindestens einen in Schritt c) auf das Substrat aufgebrachten Schicht der ersten wässrigen Suspension aufgebracht. Das Aufbringen der mindestens einen Schicht der zweiten wässrigen Suspension kann beispielsweise mittels Tauchen, Pinseln, Sprühauftragung oder einer Kombination hiervon erfolgen. Beispielsweise kann mindestens eine Schicht der zweiten wässrigen Suspension mit einer mittleren Schichtdicke von mindestens 20 µm, bevorzugt von 20 µm bis 150 µm, besonders bevorzugt von 30 µm bis 100 µm, auf der mindestens einen in Schritt c) auf das Substrat aufgebrachten Schicht der ersten wässrigen Suspension aufgebracht werden.

In Schritt e) des erfindungsgemäßen Verfahrens wird das Substrat einem Sinterprozess unterzogen. Dies erfolgt nach Schritt d), d.h. nach dem Aufbringen der mindestens einen Schicht der zweiten wässrigen Suspension auf der mindestens einen auf das Substrat aufgebrachten Schicht der ersten wässrigen Suspension. Das dem Sinterprozess in Schritt e) unterzogene beschichtete Substrat weißt also sowohl die in Schritt c) aufgebrachte mindestens eine Schicht der ersten wässrigen Suspension als auch die in Schritt d) aufgebrachte mindestens eine Schicht der zweiten wässrigen Suspension auf. Somit wird in Schritt e) gleichzeitig sowohl die mindestens eine Schicht der ersten wässrigen Suspension als auch die mindestens eine Schicht der zweiten wässrigen Suspension einem Sinterprozess unterzogen. Durch den Sinterprozess kann mindestens eine das mindestens eine Refraktärmetallcarbid enthaltende erste gesinterte Schicht aus der mindestens einen Schicht der ersten wässrigen Suspension und zudem mindestens eine das mindestens eine Refraktärmetallcarbid enthaltende zweite gesinterte Schicht aus der mindestens einen Schicht der zweiten wässrigen Suspension hergestellt werden.

Das erfindungsgemäße Verfahren ermöglicht die Herstellung von Refraktärmetallcarbid-basierten Schichten auf Substraten, die als Hochtemperatur- und Verschleißschutzschichten bzw. Verschleißschutzschichtsysteme dienen können.

Beim erfindungsgemäßen Verfahren handelt es sich um ein nasskeramisches Verfahren zur Herstellung von Refraktärmetallcarbid-basierten Beschichtungen auf Substraten. Im Gegensatz zu über CVD- oder PVD-Verfahren hergestellten Schichten, zeigen die über nasskeramische Verfahren hergestellten Schichten eine isotrope Textur mit zufälliger Korngrößenorientierung, was zu einer verminderten Anfälligkeit für Rissbildung und zu einer Erhöhung des Diffusionswegs für substratschädigende Spezies führt. Aufgrund dessen weisen die erfindungsgemäß hergestellten beschichten Substrate im Vergleich zu über CVD- oder PVD-Verfahren hergestellten beschichteten Substraten einen verbesserten Schutz gegenüber in Hochtemperaturanwendungen verwendeten aggressiven Substanzen auf. Zudem ist das erfindungsgemäße nasskeramische Verfahren kostengünstiger als CVD- oder PVD-Verfahren und bietet zudem mehr Flexibilität bei den Geometrien und Größen der herstellbaren beschichteten Bauteile sowie der Schichtdicken der aufgebrachten Beschichtungen bzw. Schichten.

Ferner basiert das erfindungsgemäße Verfahren zur Herstellung beschichteter Substrate auf der Verwendung einer wässrigen Suspension. Gegenüber der Verwendung organischer Suspensionen hat die Verwendung wässriger Suspensionen diverse Vorteile. So sind wässrige Suspensionen im Gegensatz zu organischen Suspensionen kostengünstig, aus ökologischer und gesundheitlicher Sicht unbedenklich und bringen auch nicht das sicherheitstechnische Problem leicht entflammbarer Sprühnebel mit sich. Außerdem kann bei der Verwendung wässriger Suspensionen auf eine Pyrolyse zur Entfernung organischer Lösemittel verzichtet werden, die zu einem unerwünschten Eintrag von Fremdstoffen in die Beschichtung führen kann. Weiterhin ist bei der Verwendung wässriger Suspensionen im Gegensatz zur Verwendung der bekannten organischen Suspensionen ein kontrollierter Auftrag der Suspension möglich. So ist insbesondere beim Sprühauftrag der bekannten organischen Suspensionen kein kontrollierter Auftrag möglich, da die Suspensionseigenschaften während dieses Vorgangs durch Verdampfung des Lösemittels schwanken können, so dass über die Zeit keine homogenen Schichten erhalten werden können.

Im erfindungsgemäßen Verfahren werden ein oder mehrere Sinteradditive verwendet, die ausgewählt sind aus der Gruppe bestehend aus Silicium, Zirconiumborid, Refraktärmetallsiliciden sowie Mischungen hiervon. Es hat sich gezeigt, dass diese erfindungsgemäß verwendeten Sinteradditive aufgrund ihrer Eigenschaften (z.B. Schmelzpunkte, Siedepunkte, etc.) zumindest den gleichen oder sogar einen besseren Effekt auf den Verdichtungsgrad wie die im Stand der Technik als Sinteradditive verwendeten Übergangsmetalle (z.B. Cobalt, Nickel, Eisen, etc.) haben. Es kann somit durch deren Verwendung ein hoher Verdichtungsgrad der auf dem Substrat hergestellten gesinterten Schicht erreicht werden, wodurch das Substrat sehr gut vor korrosiven Medien in Hochtemperaturanwendungen geschützt wird. Die erfindungsgemäß eingesetzten Sinteradditive zeichnen sich gegenüber den im Stand der Technik verwendeten Sinteradditiven, wie z.B. Cobalt, zunächst dadurch aus, dass sie sicherheitstechnisch und gesundheitlich unbedenklich sind. Zudem wird durch deren Verwendung und somit die Vermeidung von Übergangsmetallen als Sinteradditive verhindert, dass diese Übergangsmetalle als Verunreinigung in der Schicht erhalten bleiben, was bei einer Verwendung des beschichteten Substrats in Hochtemperaturanwendungen bei der Halbleiterkristallzüchtung schädlich für die dortige Züchtungsatmosphäre wäre.

Dadurch, dass die zweite wässrige Suspension entweder kein Sinteradditiv enthält oder einen geringeren gewichtsprozentualen Anteil an Sinteradditiv enthält, als in der ersten wässrigen Suspension enthalten ist, weist die mit dem erfindungsgemäßen Verfahren auf dem Substrat hergestellte Beschichtung einen sehr vorteilhaften Schichtaufbau aus mindestens zwei verschiedenen gesinterten Schichten auf. Dieser Schichtaufbau umfasst mindestens eine auf dem Substrat angeordnete erste gesinterte Schicht, die mindestens ein Refraktärmetallcarbid und mindestens ein Sinteradditiv ausgewählt aus der Gruppe bestehend aus Silicium, Zirconiumborid, Refraktärmetallsiliciden sowie Mischungen hiervon enthält oder daraus besteht, und mindestens eine auf der mindestens einen ersten gesinterten Schicht angeordnete zweite gesinterte Schicht, die mindestens ein Refraktärmetallcarbid und optional mindestens ein Sinteradditiv ausgewählt aus der Gruppe bestehend aus Silicium, Zirconiumborid, Refraktärmetallsiliciden sowie Mischungen hiervon enthält oder daraus besteht. Das mindestens eine Sinteradditiv kann dabei zumindest teilweise auch in zersetzter Form und/oder in Form eines Reaktionsprodukts einer Reaktion des mindestens einen Sinteradditivs mit dem mindestens einen Refraktärmetallcarbid vorliegen. Da die Anwesenheit eines Sinteradditivs bzw. ein höherer Anteil eines Sinteradditivs in der erhaltenen Schicht während dem Sintervorgang zu einem höheren Verdichtungsgrad der gesinterten Schicht führen, weist nach dem Sintervorgang die zweite gesinterte Schicht des Schichtaufbaus eine geringere relative Dichte bzw. einen geringeren Verdichtungsgrad auf als die erste gesinterte Schicht. Der erhaltene Schichtaufbau weist somit einen Dichtegradienten auf, bei welchem der Verdichtungsgrad bzw. die relative Dichte mit zunehmender Entfernung vom Substrat (d.h. von der ersten gesinterten Schicht zur zweiten gesinterten Schicht) abnimmt. Beispielsweise kann die mindestens eine erste gesinterte Schicht eine relative Dichte von mindestens 70 % aufweisen und die relative Dichte der mindestens einen zweiten gesinterten Schicht um mindestens 3 % geringer sein als die relative Dichte der mindestens einen ersten gesinterten Schicht.

Aufgrund des höheren Anteils an Sinteradditiv in der ersten wässrigen Suspension weist die erste gesinterte Schicht des hergestellten beschichteten Substrats (d.h. die erste Schicht des Schichtaufbaus, die in direktem Kontakt mit dem Substrat ist) einen vergleichsweise hohen Verdichtungsgrad bzw. eine vergleichsweise hohe relative Dichte auf, weswegen das Substrat sehr gut vor aggressiven Medien in Hochtemperaturanwendungen geschützt wird. Da die zweite wässrige Suspension einen geringeren Anteil an Sinteradditiv oder gar kein Sinteradditiv enthält, enthält auch die zweite gesinterte Schicht des hergestellten beschichteten Substrats (d.h. die zweite Schicht des Schichtaufbaus) kein oder nur eine niedrige Menge an Sinteradditiv, wodurch das Risiko verringert werden kann, dass bei einer Verwendung des hergestellten beschichteten Substrats bei Hochtemperaturanwendungen in der Halbleiterkristallzüchtung Sinteradditiv aus der Beschichtung in die Züchtungsatmosphäre gelangen und diese verschmutzen kann. Hierbei kann die mindestens eine zweite gesinterte Schicht zusätzlich auch als Schutzschicht wirken, die das Risiko verringert, dass Sinteradditiv aus der mindestens einen ersten gesinterten Schicht in die Züchtungsatmosphäre gelangt. Zudem weist die mindestens eine zweite gesinterte Schicht aufgrund des geringeren Anteils an Sinteradditiv oder wegen des Fehlens des Sinteradditivs in der zweiten wässrigen Suspension einen geringeren Verdichtungsgrad bzw. eine geringere relative Dichte als die mindestens eine erste gesinterte Schicht auf. Die daraus resultierende höhere Porosität der mindestens einen zweiten gesinterten Schicht führt zu Vorteilen bei der Anwendung des beschichteten Substrats in Hochtemperaturanwendungen bei der Halbleiterkristallzüchtung, da durch diese höhere Porosität eine größere Kontaktfläche für die in der Kristallzüchtung eingesetzte Schmelze erhalten wird, wodurch die Verdampfungsrate und damit auch die Wachstumsrate erhöht werden kann.

Durch das eben beschriebene durch das erfindungsgemäße Verfahren erhaltene Schichtsystem ist das erfindungsgemäß hergestellte beschichtete Substrat folglich besonders gut zur Verwendung in Hochtemperaturanwendungen, wie z.B. bei der Halbleiterkristallzüchtung, geeignet.

Durch die Wahl der Menge an Sinteradditiv in der ersten und zweiten wässrigen Suspension sowie optional auch die Anpassung der Sinterparameter kann die relative Dichte in den einzelnen Schichten des Schichtsystems so eingestellt werden, dass ein gewünschter Dichtegradient innerhalb des Schichtsystems erreicht werden kann. Hierbei ist es insbesondere vorteilhaft, wenn das Schichtsystem einen geringen Dichtegradienten aufweist, da das Schichtsystem so thermisch noch stabiler ist.

Das mit dem erfindungsgemäßen Verfahren herstellbare beschichtete Substrat kann beispielsweise als Gallium-Verdampfer bzw. Teil eines Gallium-Verdampfers in einem zur Züchtung von Galliumnitrid-Halbleiterkristallen verwendbaren VPE-GaN-Reaktor eingesetzt werden, wobei das im erfindungsgemäßen Verfahren erhaltene Schichtsystem dann als Beschichtung des Gallium-Verdampfers fungiert. In diesem Fall kann durch die mindestens eine erste gesinterte Schicht des Schichtsystems (d.h. die aus der ersten wässrigen Suspension resultierende gesinterte Schicht) aufgrund der höheren relativen Dichte besonders gut das Grundmaterial des Gallium-Verdampfers vor der korrosiven Gallium-Schmelze geschützt werden, wohingegen durch die niedrigere relative Dichte sowie die höhere Porosität der mindestens einen zweiten gesinterten Schicht des Schichtsystems (d.h. der aus der zweiten wässrigen Suspension resultierenden gesinterten Schicht) die Gallium-Verdampfungsrate und damit auch die Galliumnitrid-Wachstumsrate erhöht werden kann, da eine größere Kontaktfläche zur Gallium-Schmelze besteht.

Vorzugsweise wird das mindestens eine beschichtete Substrat zwischen Schritt c) und d) keinem Sinterprozess unterzogen. Das bedeutet, dass das mit der mindestens einen Schicht der ersten wässrigen Suspension beschichtete Substrat vorzugsweise keinem Sinterprozess unterzogen wird, bevor nicht die mindesten eine Schicht der zweiten wässrigen Suspension auf der mindestens einen auf das Substrat aufgebrachten Schicht der ersten wässrigen Suspension aufgebracht wurde. Dadurch, dass das beschichtete Substrat erst nach Schritt d) einem Sinterprozess unterzogen wird, können die in Schritt c) aufgebrachte mindestens eine Schicht der ersten wässrigen Suspension und die in Schritt d) aufgebrachte mindestens eine Schicht der zweiten wässrigen Suspension gleichzeitig in einem Sinterprozess gesintert werden. Ein separates Sintern jeder der beiden Schichten für sich nach dem jeweiligen Aufbringen der Schicht wird dadurch vermieden, wodurch ein Sinterschritt eingespart wird. In der Folge ist das Verfahren schneller und kostengünstiger. Zudem kann es beim Auftragen der mindestens einen Schicht der zweiten wässrigen Suspension auf eine bereits gesinterte Schicht der ersten wässrigen Suspension zu einer Schwächung der Anbindung aufgrund fehlender Infiltration und damit bei thermischen Spannungen leichter zur Delamination kommen. Dies kann durch ein gemeinsames Sintern der beiden in Schritt c) und d) aufgetragenen Schichten in einem Sinterprozess nach Schritt d) vermieden werden.

In Schritt c) des erfindungsgemäßen Verfahrens kann die mindestens eine Schicht der ersten wässrigen Suspension auf der gesamten Oberfläche des Substrats oder nur auf einem oder mehreren Abschnitten der Oberfläche des Substrats aufgebracht werden. In Schritt d) des erfindungsgemäßen Verfahrens kann die mindestens eine Schicht der zweiten wässrigen Suspension auf der gesamten in Schritt c) aufgebrachten mindestens einen Schicht der ersten wässrigen Suspension oder nur auf einem oder mehreren Abschnitten der in Schritt c) aufgebrachten mindestens einen Schicht der ersten wässrigen Suspension aufgebracht werden. Handelt es sich bei dem Substrat um einen Tiegel, kann beispielsweise in Schritt c) die mindestens eine Schicht der ersten wässrigen Suspension auf der gesamten Oberfläche des Tiegels aufgebracht werden und in Schritt d) die mindestens eine Schicht der zweiten wässrigen Suspension nur auf dem Abschnitt der mindestens einen Schicht der ersten wässrigen Suspension, die sich auf der Innenseite oder den Innenseiten des Tiegels befindet, aufgebracht werden.

Eine bevorzugte Variante des erfindungsgemäßen Verfahrens zeichnet sich dadurch aus, dass
- das Substrat ein Material enthält oder aus diesem besteht, welches ausgewählt ist aus der Gruppe bestehend aus Graphit, bevorzugt iso-Graphit, kohlenfaserverstärktem Kohlenstoff (CFC), C/SiC-Faserverbundwerkstoffen, SiC/SiC-Faserverbundwerkstoffen, carbidischen Keramiken, nitridischen Keramiken, oxidischen Keramiken, und Mischungen hiervon, und/oder
- die Refraktärmetallsilicide (in Schritt a) und/oder in Schritt b)) ausgewählt sind aus der Gruppe bestehend aus Titansiliciden, Zirconiumsiliciden, Hafniumsiliciden, Vanadiumsiliciden, Niobsiliciden, Tantalsiliciden, Chromsiliciden, Molybdänsiliciden, Wolframsiliciden, und Mischungen hiervon, und/oder
- das mindestens eine Refraktärmetallcarbid (in Schritt a) und/oder in Schritt b)) ausgewählt ist aus der Gruppe bestehend aus Titancarbiden, Zirconiumcarbiden, Hafniumcarbiden, Vanadiumcarbiden, Niobcarbiden, Tantalcarbiden, Chromcarbiden, Molybdäncarbiden, Wolframcarbiden, und Mischungen hiervon.

Aufgrund der ökologisch, gesundheitlich und sicherheitstechnisch unbedenklichen Verwendung, kombiniert mit einem Schmelztemperaturbereich zwischen 1400 °C und 2200 °C, sind die Refraktärmetallsilicide ausgewählt aus der Gruppe bestehend aus Titansiliciden, Zirconiumsiliciden, Hafniumsiliciden, Vanadiumsiliciden, Niobsiliciden, Tantalsiliciden, Chromsiliciden, Molybdänsiliciden, Wolframsiliciden, und Mischungen hiervon optimal als Sinteradditive für den Hochtemperatursinterprozess geeignet. Durch deren Verwendung als Sinteradditiv kann erreicht werden, dass es während der Aufheizphase zur Bildung der gewünschten Schmelzphase kommt und eine günstige Umlagerung der Partikel zur Steigerung der Sinteraktivität vor der aktiven Versinterung stattfindet. Die Schmelztemperatur des Sinteradditivs kann somit kleiner sein als die Sintertemperatur. Zudem kann so die Siedetemperatur des Sinteradditivs unter den gegebenen Druckbedingungen deutlich größer sein als die verwendete Sintertemperatur, wodurch eine gewisse Stabilität der Flüssigphase über den gesamten Sinterprozess gewährleistet und ein mögliches Abdampfen vermieden wird. Außerdem kann so die Schmelztemperatur der Sinteradditive unterhalb der Anwendungstemperatur der Refraktärmetallcarbid-Beschichtung (z.B. TaC-Beschichtung) liegen, wodurch ein eventuelles Abdampfen des Sinteradditivs in der Anwendung vermieden wird.

Besonders vorteilhaft ist es, wenn es sich bei dem mindestens einen Sinteradditiv um MoSi₂, TaSi₂ oder Mischungen hiervon handelt. So weisen diese mit einem Schmelzpunkt von ca. 2050°C eine hohe Temperaturstabilität auf und sind somit besonders für die Verwendung bei hohen Einsatztemperaturen z.B. in Reaktorinnenaufbauten geeignet.

Ganz besonders bevorzugt handelt es sich beim dem mindestens einen Refraktärmetallcarbid um Tantalcarbid. Tantalcarbid ermöglicht eine besonders gute Schutzwirkung für das Substrat.

Das Substrat kann vorzugsweise ein Material enthalten oder aus diesem bestehen, welches ausgewählt ist aus der Gruppe bestehend aus Graphit, bevorzugt iso-Graphit, carbidischen Keramiken, nitridischen Keramiken, oxidischen Keramiken, und Mischungen hiervon.

Das Substrat kann vorzugsweise ein Material enthalten oder aus diesem bestehen, welches ausgewählt ist aus der Gruppe bestehend aus Graphit, bevorzugt iso-Graphit, kohlenfaserverstärktem Kohlenstoff (CFC), C/SiC-Faserverbundwerkstoffen, SiC/SiC-Faserverbundwerkstoffen, und Mischungen hiervon.

Kohlenstoff-basierte Substrate und SiC-basierte Substrate zeigen beim Auftragen einer wässrigen Suspension ein erhöhtes Infiltrationsverhalten. In der Folge ist das erfindungsgemäße Verfahren besonders für solche Substrate geeignet.

Ganz besonders bevorzugt enthält das Substrat Graphit, bevorzugt iso-Graphit, oder besteht daraus.

Eine weitere bevorzugte Variante des erfindungsgemäßen Verfahrens ist dadurch gekennzeichnet, dass das mindestens eine Refraktärmetallcarbid und das mindestens eine Sinteradditiv jeweils partikulär vorliegen, wobei die mittlere Partikelgröße der Partikel des mindestens einen Sinteradditivs weniger als 5 µm beträgt und/oder kleiner ist als die mittlere Partikelgröße der Partikel des mindestens einen Refraktärmetallcarbids. Durch eine Partikelgröße der Partikel des mindestens einen Sinteradditives von weniger als 5 µm können größere Löcher oder sogar ein Strukturverlust der Beschichtung nach dem Sinterprozess vermieden werden. Eine mittlere Partikelgröße der Partikel des mindestens einen Sinteradditivs, die kleiner ist als die mittlere Partikelgröße der Partikel des mindestens einen Refraktärmetallcarbids, führt zu dem Vorteil, dass sich die Sinteradditivpartikel in den Lücken der Refraktärmetallcarbid-Schicht besser anlagern können. Die mittlere Partikelgröße der Partikel des mindestens einen Refraktärmetallcarbids kann vorzugsweise im Bereich zwischen 0,2 und 2 µm liegen.

Die mittlere Partikelgröße der Partikel des mindestens einen Refraktärmetallcarbids und/oder die mittlere Partikelgröße der Partikel des mindestens einen Sinteradditivs kann beispielsweise bestimmt werden mittels Laserbeugung (DIN 13320:2020-01.

Gemäß einer weiteren bevorzugten Variante des erfindungsgemäßen Verfahrens liegt das mindestens eine Refraktärmetallcarbid als Pulvermischung vor, die sich in der mittleren Partikelgröße der Partikel unterscheidende Pulver, vorzugsweise des gleichen Refraktärmetallcarbids, enthält oder daraus besteht. Mit anderen Worten wird hier als das mindestens eine Refraktärmetallcarbid eine Pulvermischung verwendet, die unterschiedliche Refraktärmetallcarbid-Partikel - vorzugsweise des gleichen Refraktärmetallcarbids - enthält, wobei sich diese Partikel in ihrer mittleren Partikelgröße voneinander unterscheiden. Beispielsweise kann die Pulvermischung zwei Sorten von Partikeln - vorzugsweise des gleichen Refraktärmetallcarbids - enthalten, wobei der mittlere Partikeldurchmesser der Partikel der ersten Sorte größer ist als der mittlere Partikeldurchmesser der Partikel der zweiten Sorte. Zum Beispiel können zum Erhalt einer solchen Pulvermischung verschiedene Pulver des gleichen Refraktärmetallcarbids in bestimmten Verhältnissen von nano- und mikrometergroßen Partikeln miteinander gemischt werden. Dadurch, dass das mindestens eine Refraktärmetallcarbid als Pulvermischung vorliegt, kann die Anordnung der Refraktärmetallcarbid-Pulverpartikel auf dem Substrat lückenfreier gestaltet werden, da offene Zwischenräume besser gefüllt werden können. Auf diese Weise kann unabhängig von der Anwesenheit und der Menge eines Sinteradditivs in der Schicht die relative Dichte der hergestellten Schicht erhöht.

Vorzugsweise liegt das mindestens eine Refraktärmetallcarbid bei der Herstellung der zweiten wässrigen Suspension in Schritt b) als Pulvermischung vor, die sich in der mittleren Partikelgröße der Partikel unterscheidende Pulver des gleichen Refraktärmetallcarbids enthält oder daraus besteht, wobei die zweite wässrige Suspension vorzugsweise kein Sinteradditiv enthält. Auf diese Weise kann die relative Dichte der aus der mindestens einen zweiten Suspension resultierenden Schicht (vorzugsweise ohne Verwendung eines Sinteradditives) erhöht werden, sodass ein geringerer Dichtegradient in der Schichtstruktur resultiert, wodurch die thermische Stabilität der Schichtstruktur sowie auch die quasi-diffusionshemmende Wirkung (z.B. bezüglich der Diffusion von Verunreinigungen in eine Züchtungsatmosphäre) erhöht wird. So können durch einen geringeren Dichteunterschied ein abrupter Wechsel in den Schichtdichten und daraus resultierende ungleichmäßig verteilte thermische Spannungen im Schichtsystem vermieden werden, die zu Rissen, Delamination oder im schlimmsten Fall zum Ausfall des Schichtsystems führen können. Das Schichtsystem ist folglich thermisch stabiler. Zudem weist durch die Verwendung von Refraktärmetallcarbid-Partikeln unterschiedlicher Partikelgröße auch die zweite Schicht noch eine vergleichsweise geringe Porosität auf, so dass sie als Trennschicht zur äußeren Atmosphäre wirken kann, woraus eine quasi-diffusionshemmende Wirkung resultiert.

Eine weitere bevorzugte Variante des erfindungsgemäßen Verfahrens zeichnet sich dadurch aus, dass die erste wässrige Suspension und/oder die zweite wässrige Suspension
- 60 bis 90 Gew.-%, bevorzugt 70 bis 85 Gew.-%, des mindestens einen Refraktärmetallcarbids, bezogen auf das Gesamtgewicht derjeweiligen wässrigen Suspension, enthält, und/oder
- 0,1 bis 20 Gew.-%, bevorzugt 0,5 bis 10 Gew.-%, des mindestens einen Sinteradditivs, bezogen auf das Gesamtgewicht derjeweiligen wässrigen Suspension, enthält.

Beispielsweise kann die erste wässrige Suspension 0,2 bis 20,0 Gew.-%, bevorzugt 0,6 bis 10,0 Gew.-% des mindestens einen Sinteradditivs, bezogen auf das Gesamtgewicht derjeweiligen wässrigen Suspension, enthalten und/oder die zweite wässrige Suspension kann 0,1 bis 19,9 Gew.-%, bevorzugt 0,5 bis 9,9 Gew.% des mindestens einen Sinteradditivs, bezogen auf das Gesamtgewicht der jeweiligen wässrigen Suspension, enthalten.

Gemäß einer weiteren bevorzugten Variante des erfindungsgemäßen Verfahrens ist der gewichtsprozentuale Anteil des mindestens einen Sinteradditivs in der zweiten wässrigen Suspension, bezogen auf das Gesamtgewicht der zweiten wässrigen Suspension, um 0,1 Gew.-% bis 20 Gew.-%, bevorzugt um 0,5 Gew.-% bis 10 Gew.-%, kleiner als der gewichtsprozentuale Anteil des mindestens einen Sinteradditivs in der ersten wässrigen Suspension, bezogen auf das Gesamtgewicht der ersten wässrigen Suspension. Auf diese Weise kann ein geringer Dichtegradient innerhalb der Schichtstruktur aus erster Schicht (d.h. der aus der ersten wässrigen Suspension resultierenden Schicht) und zweiter Schicht (d.h. der aus der zweiten wässrigen Suspension resultierenden Schicht) erhalten werden, wodurch die thermische Stabilität der Schichtstruktur sowie auch die quasi-diffusionshemmende Wirkung (z.B. bezüglich der Diffusion von Verunreinigungen in eine Züchtungsatmosphäre) erhöht wird. So können durch einen geringeren Dichteunterschied ein abrupter Wechsel in den Schichtdichten und daraus resultierende ungleichmäßig verteilte thermische Spannungen im Schichtsystem vermieden werden, die zu Rissen, Delamination oder im schlimmsten Fall zum Ausfall des Schichtsystems führen können. Das Schichtsystem ist folglich thermisch stabiler. Zudem weist durch die Verwendung des Sinteradditiv auch die zweite Schicht noch eine vergleichsweise geringe Porosität auf, so dass sie als Trennschicht zur äußeren Atmosphäre wirken kann, woraus eine quasi-diffusionshemmende Wirkung resultiert.

Beispielsweise kann der gewichtsprozentuale Anteil des mindestens einen Sinteradditivs in der zweiten wässrigen Suspension, bezogen auf das Gesamtgewicht der zweiten wässrigen Suspension, um 0,1 Gew.-% bis 19,9 Gew.-%, bevorzugt um 0,5 Gew.-% bis 9,9 Gew.-%, kleiner sein als der gewichtsprozentuale Anteil des mindestens einen Sinteradditivs in der ersten wässrigen Suspension, bezogen auf das Gesamtgewicht der ersten wässrigen Suspension.

Die mindestens eine erste wässrige Suspension und/oder die mindestens eine zweite wässrige Suspension kann mindestens eine Bindemittel ausgewählt aus der Gruppe bestehend aus Polyvinylalkoholen, Natriumbiphenyl-2-yloxiden, Polyphenyloxid, und Mischungen hiervon enthalten, wobei das mindestens eine Bindemittel vorzugweise zu einem Anteil von 0,05 bis 1 Gew.-% oder von 0,01 bis 5 Gew.-%, bezogen auf das Gesamtgewicht der jeweiligen wässrigen Suspension, in der mindestens einen ersten wässrigen Suspension und/oder der mindestens einen zweiten wässrigen Suspension enthalten sein kann.

Eine weitere bevorzugte Variante des erfindungsgemäßen Verfahrens ist dadurch gekennzeichnet, dass die Herstellung der ersten wässrigen Suspension in Schritt a) und/oder die Herstellung der zweiten wässrigen Suspension in Schritt b) durch Vermischen der Komponenten der herzustellenden Suspension mithilfe eines Dispergiergeräts erfolgt, wobei das Vermischen mithilfe des Dispergiergeräts vorzugsweise unter Verwendung von Mahlkörpern und/oder über einen Zeitraum von mindestens 12 Stunden erfolgt. Auf diese Weise kann eine optimale Durchmischung der jeweiligen wässrigen Suspension erreicht werden, sodass Inhomogenitäten in der Verteilung des Sinteradditivs und somit in der Verdichtung vermieden werden können. Beispielsweise können beim Vermischen mit dem Dispergiergerät Umdrehungsgeschwindigkeiten bis zu 1m/s verwendet werden.

Eine weitere bevorzugte Variante des erfindungsgemäßen Verfahrens zeichnet sich dadurch aus, dass das Aufbringen der mindestens einen Schicht der ersten wässrigen Suspension in Schritt c) und/oder das Aufbringen der mindestens einen Schicht der zweiten wässrigen Suspension in Schritt d)
- mittels Tauchen, Pinseln oder Sprühauftragung erfolgt, und/oder
- mit einer mittleren Schichtdicke von weniger als 150 µm, bevorzugt von 20 µm bis 100 µm, besonders bevorzugt von 30 µm bis 80 µm, erfolgt.

Für die Herstellung von einer oder mehrerer dünner, schnelltrocknender Refraktärmetallcarbid-Schichten, vorzugsweise mit Schichtdicken im Bereich von 20 µm bis 80 µm, ist die Sprühauftragung die bevorzugte Wahl. Dabei kann durch eine schnelle Rotation des Bauteils durch den Sprühstrahl eine sehr dünne Suspensionsschicht auf der Oberfläche aufgebracht werden, die je nach Feststoffgehalt der Suspension schnell bis sehr schnell trocknen kann. Bevorzugt sind dabei Feststoffgehalte des Refraktärmetallcarbid-Pulvers größer gleich 70 Gew.-% von der Gesamtsuspension. Jede aufzutragende Einzellage sollte vorzugsweise ein vergleichbares Trocknungsverhalten zeigen. Grundsätzlich wird ein schnelltrocknendes Verhalten der aufgetragenen Suspensionsschichten bevorzugt, da Dichteunterschiede zwischen Refraktärmetallcarbid und Sinteradditiv zu einer Inhomogenität in der Verteilung der Partikel führen kann, wenn die Schichten zu lange trocknen.

Eine weitere bevorzugte Variante des erfindungsgemäßen Verfahrens ist dadurch gekennzeichnet, dass zusätzlich mindestens eine dritte wässrige Suspension hergestellt wird, die mindestens ein Refraktärmetallcarbid und Wasser enthält oder daraus besteht, wobei die mindestens eine dritte wässrige Suspension kein Sinteradditiv enthält, und zwischen Schritt d) und e) mindestens eine Schicht der mindestens einen dritten wässrigen Suspension auf die mindestens eine aufgebrachte Schicht der zweiten wässrigen Suspension aufgebracht wird. Im Sinterprozess Schritt e) kann dann eine gemeinsame (gleichzeitige) Sinterung der mindestens einen Schicht der ersten wässrigen Suspension, der mindestens einen Schicht der zweiten wässrigen Suspension und der mindestens einen Schicht der dritten wässrigen Suspension erfolgen. Auf diese Weise entstehen stabile Anbindungen zwischen den Schichten, die auch bei thermischen Spannungen stabil sind. Das in der mindestens einen dritten wässrigen Suspension enthaltene mindestens eine Refraktärmetallcarbid kann mit dem in der ersten wässrigen Suspension enthaltenen Refraktärmetallcarbid und/oder mit dem in der zweiten wässrigen Suspension enthaltenen Refraktärmetallcarbid identisch sein. Vorzugsweise ist das mindestens eine in der mindestens einen dritten wässrigen Suspension enthaltene Refraktärmetallcarbid ausgewählt aus der Gruppe bestehend aus Titancarbiden, Zirconiumcarbiden, Hafniumcarbiden, Vanadiumcarbiden, Niobcarbiden, Tantalcarbiden, Chromcarbiden, Molybdäncarbiden, Wolframcarbiden, und Mischungen hiervon.

Vorzugsweise können zusätzlich mehrere dritte wässrige Suspensionen hergestellt werden, die mindestens ein Refraktärmetallcarbid und Wasser enthalten oder daraus bestehen, wobei die mehreren dritten wässrigen Suspensionen kein Sinteradditiv enthalten, und zwischen Schritt d) und e) jeweils mindestens eine Schicht von jeder der dritten wässrigen Suspensionen so übereinander auf die mindestens eine aufgebrachte Schicht der zweiten wässrigen Suspension aufgebracht werden, dass sich eine Schichtfolge aus den Schichten der dritten wässrigen Suspensionen ergibt. Auf diese Weise kann das nach dem Sintern erhaltene beschichtete Substrat eine Schichtfolge mehrerer dritter gesinterter Schichten umfassen, wobei die relative Dichte der mehreren gesinterten Schichten innerhalb dieser Schichtfolge mit zunehmendem Abstand zur mindestens einen zweiten gesinterten Schicht abnimmt. Beispielsweise kann durch die Anpassung der Sinterparameter die relative Dichte in den einzelnen Schichten der Schichtfolge so eingestellt werden, dass ein (gewünschter) Dichtegradient innerhalb der Schichtfolge erreicht werden kann.

Eine weitere bevorzugte Variante des erfindungsgemäßen Verfahrens zeichnet sich dadurch aus, dass der Sinterprozess in Schritt d)
- bei einer Temperatur von 2100 °C bis 2500 °C, bevorzugt von 2200 °C bis 2400 °C, erfolgt, und/oder
- mit einer Haltezeit von 1 h bis 15 h, bevorzugt von 2 h bis 10 h, erfolgt, und/oder
- bei einem Druck von 0,1 bar bis 10 bar, bevorzugt 0,7 bar bis 5 bar, erfolgt, und/oder
- so erfolgt, dass nach einem ersten zeitlichen Abschnitt des Sinterprozesses der Druck erhöht wird, bevorzugt um 3 bar bis 7 bar, und/oder
- unter Argon-Atmosphäre erfolgt,
erfolgt.

Durch diese Ausgestaltungen des Sinterprozesses kann einerseits erreicht werden, dass ein besonders vorteilhaftes Verhältnis zwischen dem Verdichtungsgrad in der ersten Schicht des Schichtaufbaus (d.h. der aus der ersten wässrigen Suspension resultierenden Schicht) und dem Verdichtungsgrad in der zweiten Schicht des Schichtaufbaus (d.h. der aus der zweiten wässrigen Suspension resultierenden Schicht) erhalten wird. Zudem wird durch diese Ausgestaltungen des Sinterprozesses die Stabilität der Schmelzphase über den gesamten Sinterprozess erhöht.

Durch die bevorzugte Variante, dass nach einem ersten zeitlichen Abschnitt des Sinterprozesses in Schritt e) der Druck erhöht wird, bevorzugt um 3 bar bis 7 bar, kann ein Abdampfen des Sinteradditivs, z.B. bei einer Sintertemperatur von 2300 °C, verhindert werden, wobei gleichzeitig noch die stabile Flüssigphase optimal zwischen den Partikeln verteilt wird.

Gemäß einer weiteren bevorzugten Variante des erfindungsgemäßen Verfahrens ist das Substrat ein Graphit-Substrat, vorzugsweise ein iso-Graphit-Substrat.

Die vorliegende Erfindung betrifft ferner ein beschichtetes Substrat, umfassend ein Substrat, mindestens eine auf dem Substrat angeordnete erste gesinterte Schicht, die mindestens ein Refraktärmetallcarbid und mindestens ein Sinteradditiv ausgewählt aus der Gruppe bestehend aus Silicium, Zirconiumborid, Refraktärmetallsiliciden und Mischungen hiervon, enthält oder daraus besteht, und mindestens eine auf der mindestens einen ersten Schicht angeordnete zweite gesinterte Schicht, die mindestens ein Refraktärmetallcarbid und optional mindestens ein Sinteradditiv ausgewählt aus der Gruppe bestehend aus Silicium, Zirconiumborid, Refraktärmetallsiliciden und Mischungen hiervon, enthält oder daraus besteht, wobei die mindestens eine erste Schicht eine relative Dichte von mindestens 70 % aufweist, und wobei die relative Dichte der mindestens einen zweiten Schicht um mindestens 3 % geringer ist als die relative Dichte der mindestens einen ersten Schicht.

Das Vorhandensein des mindestens einen Sinteradditivs in der ersten gesinterten Schicht und/oder in der zweiten gesinterten Schicht kann beispielsweise über eine elementare Analysemethode oder XRD-Analyse nachgewiesen werden.

Die relative Dichte kann beispielsweise über REM-Querschliffsanalyse bestimmt werden.

Das mindestens eine Sinteradditiv kann in der ersten gesinterten Schicht und/oder in der zweiten gesinterten Schicht zumindest teilweise auch in zersetzter Form und/oder in Form eines Reaktionsprodukts einer Reaktion des mindestens einen Sinteradditivs mit dem mindestens einen Refraktärmetallcarbid vorliegen.

Bei dem mindestens einen in der ersten gesinterten Schicht enthaltenen Refraktärmetallcarbid und dem mindestens einen in der zweiten gesinterten Schicht enthaltenen Refraktärmetallcarbid kann es sich um das gleiche Refraktärmetallcarbid oder um verschiedene Refraktärmetallcarbide handeln. Die zweite gesinterte Schicht kann ein Sinteradditiv ausgewählt aus der Gruppe bestehend aus Silicium, Zirconiumborid, Refraktärmetallsiliciden sowie Mischungen hiervon enthalten, wobei dann vorzugsweise der gewichtsprozentuale Anteil des mindestens einen Sinteradditivs in der zweiten gesinterten Schicht, bezogen auf das Gesamtgewicht der zweiten gesinterten Schicht, kleiner ist als der gewichtsprozentuale Anteil des mindestens einen Sinteradditivs in der ersten gesinterten Schicht, bezogen auf das Gesamtgewicht der ersten gesinterten Schicht. Bei dem mindestens einen in der ersten gesinterten Schicht enthaltenen Sinteradditiv und dem mindestens einen in der zweiten gesinterten Schicht enthaltenen Sinteradditiv kann es sich um das gleiche Sinteradditiv oder um verschiedene Sinteradditive handeln. Alternativ kann die zweite gesinterte Schicht auch kein Sinteradditiv enthalten.

Das erfindungsgemäße beschichtete Substrat weist einen sehr vorteilhaften Schichtaufbau aus mindestens zwei verschiedenen gesinterten Schichten auf. Durch die relative Dichte der mindestens einen ersten gesinterten Schicht von mindestens 70 % ist das Substrat sehr gut vor aggressiven bzw. korrosiven Substanzen in Hochtemperaturanwendung, wie z.B. der Schmelze bei der Halbleiterkristallzüchtung, geschützt. Die mindestens eine zweite gesinterte Schicht weist eine um mindestens 3 % geringere relative Dichte bzw. einen geringeren Verdichtungsgrad auf als die mindestens eine erste gesinterte Schicht. Der erhaltene Schichtaufbau weist somit einen Dichtgradienten auf, bei welchem der Verdichtungsgrad bzw. die relative Dichte mit zunehmender Entfernung vom Substrat - d.h. von der mindestens einen ersten gesinterten Schicht zur mindestens einen zweiten gesinterten Schicht - abnimmt.

Die daraus resultierende höhere Porosität der mindestens einen zweiten gesinterten Schicht im Vergleich zur mindestens einen ersten gesinterten Schicht führt zu Vorteilen bei der Anwendung des beschichteten Substrats in Hochtemperaturanwendungen bei der Halbleiterkristallzüchtung, da durch diese höhere Porosität eine größere Kontaktfläche für die in der Kristallzüchtung eingesetzte Schmelze erhalten wird, wodurch die Verdampfungsrate und damit auch die Wachstumsrate erhöht werden kann.

Durch dieses vorteilhafte Schichtsystem ist das erfindungsgemäße beschichtete Substrat folglich besonders gut zur Verwendung in Hochtemperaturanwendungen, wie z.B. bei der Halbleiterkristallzüchtung, geeignet.

Eine bevorzugte Ausführungsform des erfindungsgemäßen beschichteten Substrats zeichnet sich dadurch aus, dass
- das Substrat ein Material enthält oder aus diesem besteht, welches ausgewählt ist aus der Gruppe bestehend aus Graphit, bevorzugt iso-Graphit, kohlenfaserverstärktem Kohlenstoff (CFC), C/SiC-Faserverbundwerkstoffen, SiC/SiC-Faserverbundwerkstoffen, carbidischen Keramiken, nitridischen Keramiken, oxidischen Keramiken, und Mischungen hiervon, und/oder
- die Refraktärmetallsilicide (in der ersten gesinterten Schicht und/oder in der zweiten gesinterten Schicht) ausgewählt sind aus der Gruppe bestehend aus Titansiliciden, Zirconiumsiliciden, Hafniumsiliciden, Vanadiumsiliciden, Niobsiliciden, Tantalsiliciden, Chromsiliciden, Molybdänsiliciden, Wolframsiliciden, und Mischungen hiervon, und/oder
- das mindestens eine Refraktärmetallcarbid (in der ersten gesinterten Schicht und/oder in der zweiten gesinterten Schicht) ausgewählt ist aus der Gruppe bestehend aus Titancarbiden, Zirconiumcarbiden, Hafniumcarbiden, Vanadiumcarbiden, Niobcarbiden, Tantalcarbiden, Chromcarbiden, Molybdäncarbiden, Wolframcarbiden, und Mischungen hiervon.

Ganz besonders bevorzugt handelt es sich beim dem mindestens einen Refraktärmetallcarbid um Tantalcarbid.

Das Substrat kann vorzugsweise ein Material enthalten oder aus diesem bestehen, welches ausgewählt ist aus der Gruppe bestehend aus Graphit, bevorzugt iso-Graphit, carbidischen Keramiken, nitridischen Keramiken, oxidischen Keramiken, und Mischungen hiervon.

Das Substrat kann vorzugsweise ein Material enthalten oder aus diesem bestehen, welches ausgewählt ist aus der Gruppe bestehend aus Graphit, bevorzugt iso-Graphit, kohlenfaserverstärktem Kohlenstoff (CFC), C/SiC-Faserverbundwerkstoffen, SiC/SiC-Faserverbundwerkstoffen, und Mischungen hiervon.

Ganz besonders bevorzugt enthält das Substrat Graphit, bevorzugt iso-Graphit, oder besteht daraus.

Bei dem Substrat kann es sich vorzugsweise um ein Kohlenstoff-Substrat, besonders bevorzugt um ein Graphit-Substrat, ganz besonders bevorzugt um ein iso-Graphit-Substrat, handeln. Unter iso-Graphit wird dabei Graphit verstanden, der nach dem Verfahren des isostatischen Pressens hergestellt wurde. Beispielsweise kann das Substrat ein Tiegel, vorzugsweise ein Kohlenstoff-Tiegel, besonders bevorzugt ein Graphit-Tiegel, ganz besonders bevorzugt ein iso-Graphit-Tiegel, sein.

Weiterhin ist es bevorzugt, dass die mindestens eine erste gesinterte Schicht und die mindestens eine zweite gesinterte Schicht im Wesentlichen kein Cobalt, kein Nickel und kein Eisen enthalten. Unter "im Wesentlichen kein Cobalt, kein Nickel und kein Eisen" ist hierbei zu verstehen, dass die mindestens eine erste gesinterte Schicht und die mindestens eine zweite gesinterte Schicht minimale Mengen Cobalt, Nickel und/oder Eisen enthalten können, die nicht bei der Verwendung des beschichteten Substrats, z.B. bei der Halbleiterkristallzüchtung, stören. Vorzugsweise wird unter der Formulierung, dass die mindestens eine erste gesinterte Schicht und die mindestens eine zweite gesinterte Schicht im Wesentlichen kein Cobalt, kein Nickel und kein Eisen enthalten, verstanden, dass die mindestens eine erste gesinterte Schicht und die mindestens eine zweite gesinterte Schicht nicht mehr als 1 Gew.-%, besonders bevorzugt nicht mehr als 0,1 Gew.-%, Cobalt, nicht mehr als 1 Gew.-%, besonders bevorzugt nicht mehr als 0,1 Gew.-%, Nickel und nicht mehr als 1 Gew.-%, besonders bevorzugt nicht mehr als 0,1 Gew.-%, Eisen, bezogen auf das Gesamtgewicht der mindestens einen ersten gesinterten Schicht und der mindestens einen zweiten gesinterten Schicht, enthalten. Besonders bevorzugt enthalten die mindestens eine erste gesinterte Schicht und die mindestens eine zweite gesinterte Schicht kein Cobalt, kein Nickel und kein Eisen.

Durch die Verwendung eines oder mehrerer Sinteradditive ausgewählt aus der Gruppe bestehend aus Silicium, Zirconiumborid, Refraktärmetallsiliciden und Mischungen hiervon, kann auf die Verwendung von Cobalt, Nickel und Eisen als Sinteradditiv verzichtet werden. In der Folge enthalten auch die mindestens eine erste gesinterte Schicht und die mindestens eine zweite gesinterte Schicht vorzugsweise (im Wesentlichen) kein Cobalt, kein Nickel und kein Eisen. In der Folge kann Cobalt, Nickel und Eisen nicht bei einer Anwendung, z.B. bei einer Hochtemperaturanwendung in der Halbleiterkristallzüchtung, als Verunreinigung aus dem beschichteten Substrat austreten und die Anwendung negativ beeinflussen.

Ferner ist es bevorzugt, dass die Körner ausgehend von der Korngröße der Ausgangssprühschicht bzw. der aufgesprühten Partikel um mindestens einen Faktor 1,5, bevorzugt einen Faktor in einem Bereich von 1,5 bis 10, besonders bevorzugt einen Faktor in einem Bereich von 1,5 bis 5, wachsen.

Eine weitere bevorzugte Ausführungsform des erfindungsgemäßen beschichteten Substrats ist dadurch gekennzeichnet, dass die mindestens eine erste gesinterte Schicht
- eine relative Dichte von mehr als 75 %, bevorzugt von mehr als 80 %, besonders bevorzugt von mehr als 90 %, ganz besonders bevorzugt von mehr als 95 % aufweist, und/oder
- eine Permeabilität von weniger als 1 e⁻¹¹ m², bevorzugt von weniger als 1 e⁻¹³ m², aufweist, und/oder
- eine Haftfestigkeit von mindestens 2 MPa, bevorzugt von mindestens 4 MPa, aufweist, und/oder
- eine mittlere Schichtdicke von mindestens 20 µm, bevorzugt von 20 µm bis 150 µm, besonders bevorzugt von 30 µm bis 100 µm, aufweist.

Weiterhin ist es bevorzugt, dass die mindestens eine zweite gesinterte Schicht
- eine relative Dichte aufweist, die mindestens 5 %, bevorzugt mindestens 10 %, besonders bevorzugt 10 % bis 30 %, ganz besonders bevorzugt 15 % bis 25 %, insbesondere 18 % bis 22 %, geringer ist als die relative Dichte der mindestens einen ersten gesinterten Schicht, und/oder
- eine Permeabilität von weniger als 1 e⁻¹¹ m², bevorzugt von weniger als 1 e⁻¹² m², aufweist, und/oder
- eine Haftfestigkeit von mindestens 2 MPa, bevorzugt von mindestens 4 MPa, aufweist, und/oder
- eine mittlere Schichtdicke von mindestens 20 µm, bevorzugt von 20 µm bis 150 µm, besonders bevorzugt von 30 µm bis 100 µm, aufweist.

Die relative Dichte kann beispielsweise über REM-Querschliffsanalyse bestimmt werden. Die mittlere Schichtdicke kann beispielsweise über Querschliffsanalyse bestimmt werden. Die Permeabilität kann beispielsweise über einen Aufbau zur Messung eines Gasvolumenstroms durch die Probe in Abhängigkeit eines Druckunterschieds durch die Probe und die Umrechnung in Darcy's Permeabilitätskonstante bestimmt werden. Die Haftfestigkeit kann beispielsweise über Zugversuche bestimmt werden.

Vorzugsweise weist die mindestens eine erste gesinterte Schicht eine geringere Permeabilität auf als die mindestens eine zweite gesinterte Schicht.

Vorzugsweise weist die mindestens eine erste gesinterte Schicht eine höhere Haftfestigkeit auf als die mindestens eine zweite gesinterte Schicht.

Vorzugsweise weist die mindestens eine erste gesinterte Schicht eine geringere Schichtdicke auf als die mindestens eine zweite gesinterte Schicht.

Besonders bevorzugt weist die mindestens eine erste gesinterte Schicht eine geringere Permeabilität, eine höhere Haftfestigkeit und eine geringere Schichtdicke auf als die mindestens eine zweite gesinterte Schicht.

Gemäß einer weiteren bevorzugten Ausführungsform des erfindungsgemäßen beschichteten Substrats umfasst das beschichtete Substrat mindestens eine auf der mindestens einen zweiten gesinterten Schicht angeordnete dritte gesinterte Schicht, die mindestens ein Refraktärmetallcarbid enthält oder daraus besteht, wobei die mindestens eine dritte gesinterte Schicht kein Sinteradditiv enthält, und wobei die relative Dichte der mindestens einen dritten gesinterten Schicht um mindestens 5 %, bevorzugt mindestens 10 %, besonders bevorzugt 10 % bis 30 %, ganz besonders bevorzugt 15 % bis 25 %, insbesondere 18 % bis 22 %, geringer ist als die relative Dichte der mindestens einen zweiten gesinterten Schicht. Das in der mindestens einen dritten gesinterten Schicht enthaltene mindestens eine Refraktärmetallcarbid kann mit dem in der mindestens einen ersten gesinterten Schicht enthaltenen Refraktärmetallcarbid und/oder mit dem in der mindestens einen zweiten gesinterten Schicht enthaltenen Refraktärmetallcarbid identisch sein. Vorzugsweise ist das mindestens eine in der mindestens einen dritten gesinterten Schicht enthaltene Refraktärmetallcarbid ausgewählt aus der Gruppe bestehend aus Titancarbiden, Zirconiumcarbiden, Hafniumcarbiden, Vanadiumcarbiden, Niobcarbiden, Tantalcarbiden, Chromcarbiden, Molybdäncarbiden, Wolframcarbiden, und Mischungen hiervon.

Weiterhin ist es bevorzugt, dass die mindestens eine dritte gesinterte Schicht eine Schichtfolge mehrerer gesinterter Schichten umfasst, wobei die relative Dichte der mehreren gesinterten Schichten innerhalb der Schichtfolge mit zunehmendem Abstand zur mindestens einen zweiten gesinterten Schicht abnimmt. Die relative Dichte kann beispielsweise über REM-Querschliffsanalyse bestimmt werden.

Ferner ist es bevorzugt, dass das erfindungsgemäße beschichtete Substrat mit dem erfindungsgemäßen Verfahren zur Herstellung von beschichteten Substraten herstellbar oder hergestellt ist

Die vorliegende Erfindung betrifft außerdem die Verwendung des erfindungsgemäßen beschichteten Substrats in der Halbleiterkristallzüchtung, wobei es sich bei dem beschichteten Substrat vorzugsweise um einen beschichteten Tiegel handelt.

Das erfindungsgemäße beschichtete Substrat kann beispielsweise als Gallium-Verdampfer bzw. Teil eines Gallium-Verdampfers in einem zur Züchtung von Galliumnitrid-Halbleiterkristallen verwendbaren VPE-GaN-Reaktor eingesetzt werden, wobei das im erfindungsgemäßen beschichteten Substrat enthaltene Schichtsystem dann als Beschichtung des Gallium-Verdampfers fungiert. In diesem Fall kann durch die mindestens eine erste gesinterte Schicht aufgrund der höheren relativen Dichte besonders gut das Grundmaterial des Gallium-Verdampfers vor der korrosiven Gallium-Schmelze geschützt werden, wohingegen durch die niedrigere relative Dichte sowie die höhere Porosität der mindestens einen zweiten gesinterten Schicht des Schichtsystems die Gallium-Verdampfungsrate und damit auch die Galliumnitrid-Wachstumsrate erhöht werden kann, da eine größere Kontaktfläche zur Gallium-Schmelze besteht.

Die vorliegende Erfindung wird anhand der nachfolgenden Figuren und Beispiele näher erläutert, ohne die Erfindung auf die speziell dargestellten Parameter zu beschränken.

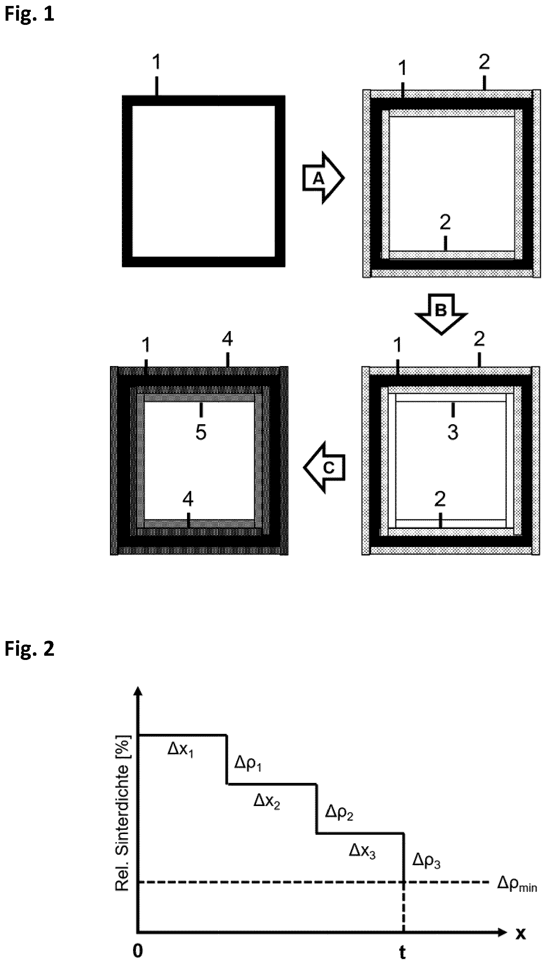

In Fig. 1 ist ein Teil einer beispielhaften Variante des erfindungsgemäßen Verfahrens schematisch dargestellt. In diesem Beispiel wird als Substrat 1 ein (geschlossener) Tiegel, vorzugsweise ein Graphit-Tiegel, z.B. ein iso-Graphit-Tiegel, verwendet, der in der Halbleiterkristallzüchtung verwendet werden soll. Bei dieser Anwendung ist im Inneren des Tiegels eine ZüchtungsAtmosphäre vorhanden. In Fig. 1 wird nun schematisch - als Schritt A - ein Aufbringen einer ersten Schicht 2 auf der gesamten Oberfläche des Substrats 1 sowie - als Schritt B - ein Aufbringen einer zweiten Schicht 3 auf dem Teil der ersten Schicht 2, welche auf der Innenseite des Substrats 1 aufgebracht ist, beschrieben. Es wird somit eine gezielte Schichtarchitektur bzw. ein gezielter Schichtaufbau aus zwei Schichten erhalten. Die erste Schicht 2 wird dabei durch Aufbringen einer Schicht einer ersten wässrigen Suspension erhalten, die aus Tantalcarbid, Wasser und einem Sinteradditiv ausgewählt aus der Gruppe bestehend aus Silicium, Zirconiumborid, Refraktärmetallsiliciden sowie Mischungen hiervon besteht. Die zweite Schicht 3 wird durch Aufbringen einer Schicht einer zweiten wässrigen Suspension erhalten, die aus Tantalcarbid und Wasser besteht und somit kein Sinteradditiv enthält. Das Aufbringen der ersten Schicht 2 in Schritt A und das Aufbringen der zweiten Schicht 3 in Schritt B kann jeweils mittels Sprühauftragung erfolgen. Erst nach Aufbringen der zweiten Schicht 3 erfolgt in Schritt C ein Sintern des (beschichteten) Substrats, so dass die erste Schicht 2 und die zweite Schicht 3 gemeinsam gesintert werden, wobei aus der ersten Schicht 2 die erste gesinterte Schicht 4 entsteht und aus der zweiten Schicht 3 die zweite gesinterte Schicht 5 entsteht. Beim Sintern erfolgt eine gezielte Verdichtung der Schichtarchitektur bzw. des Schichtaufbaus.

Das so erhaltene beschichtete Substrat weist einen sehr vorteilhaften Schichtaufbau aus zwei verschiedenen gesinterten Schichten 5, 6 auf. Durch die Verwendung des Sinteradditivs in der ersten Schicht 2, weist die gesinterte Schicht 4 eine hohe relative Dichte auf, durch die das Substrat sehr gut durch die bei der Halbleiterkristallzüchtung verwendete korrosive Schmelze geschützt wird. Die zweite gesinterte Schicht 5 weist aufgrund des in der zweiten Schicht 3 nicht vorhandenen Sinteradditivs eine geringere relative Dichte auf als die erste gesinterte Schicht 4. Der erhaltene Schichtaufbau weist somit einen Dichtgradienten auf, bei welchem der Verdichtungsgrad bzw. die relative Dichte mit zunehmender Entfernung vom Substrat (d.h. von der ersten gesinterten Schicht 4 zur zweiten gesinterten Schicht 5) abnimmt. Die daraus resultierende höhere Porosität der zweiten gesinterten Schicht 5 im Vergleich zur ersten gesinterten Schicht 4 führt zu Vorteilen bei der Anwendung des beschichteten Substrats bei der Halbleiterkristallzüchtung, da durch diese höhere Porosität eine größere Kontaktfläche für die in der Kristallzüchtung eingesetzte Schmelze erhalten wird, wodurch die Verdampfungsrate und damit auch die Wachstumsrate erhöht werden kann.

In Fig. 2 ist für ein beispielhaftes erfindungsgemäßes beschichtetes Substrat die Dichteverteilung innerhalb des Schichtsystems graphisch dargestellt, wobei im gezeigten Graphen die relative Sinterdichte in Abhängigkeit von der Schichtdicke (bzw. dem Abstand von der Substratoberfläche) dargestellt ist. Das hier beschriebene beispielhafte beschichtete Substrat weist einen Schichtaufbau mit drei gesinterten Schichten verschiedener relativer Dichte auf. Der Punkt 0 der x-Achse stellt dabei die Substratoberfläche dar, wobei t die Schichtdicke der gesamten Beschichtung mit der ersten, zweiten und dritten gesinterten Schicht angibt. Die Δx-Werte geben die Distanz zwischen zwei Schichtlagen unterschiedlicher Dichte an, sodass Δx₁ der Dicke der ersten gesinterten Schicht, Δx₂ der Dicke der zweiten gesinterten Schicht und Δx₃ der Dicke der dritten gesinterten Schicht entspricht. Der Unterschied in der Dichte der angrenzenden gesinterten Schichten wird mit Δρ quantifiziert. Die erste gesinterte Schicht, d.h. die direkt mit dem Substrat in Kontakt stehende gesinterte Schicht, hat eine relative Dichte von mindestens 70 %. Im in Fig. 2 gezeigten Graphen ist nun zu erkennen, dass die relative Dichte in den gesinterten Schichten des Schichtsystems mit zunehmender Entfernung vom Substrat abnimmt, d.h. die zweite gesinterte Schicht weist eine (um mindestens 5 %) geringere relative Dichte auf als die erste gesinterte Schicht und die dritte gesinterte Schicht weist eine (um mindestens 5 %) geringere relative Dichte auf als die zweite gesinterte Schicht. Es ergibt sich somit ein Dichtegradient innerhalb des Schichtsystems. Um die graphisch dargestellten Werte zu ermitteln, kann über eine REM-Aufnahme eines polierten Querschliffs unterschieden werden, über welches Δx eine einheitliche Dichte vorliegt. Anhand des ermittelten Δx und der, während der Beschichtung bestimmten, Masse dieses Bereichs, kann dann für Δx eine Sinterdichte berechnet werden. Der Unterschied in der Dichte der angrenzenden Schichten, mit einer Ausdehnung von Δx, wird mit Δρ quantifiziert.

### Ausführungsbeispiel 1

Zunächst wurden eine erste wässrige Suspension bestehend aus 80 Gew.-% Tantalcarbid, 1 Gew.-% Silicium als Sinteradditiv und 19 Gew.-% Wasser sowie eine zweite wässrige Suspension bestehend aus 80 Gew.-% Tantalcarbid und 20 Gew.-% Wasser hergestellt. Die zweite wässrige Suspension enthält somit kein Sinteradditiv. Die mittlere Pulverpartikelgröße der TaC-Partikel liegt vorzugsweise im Bereich zwischen 0,2 und 2 µm. Zur Herstellung der wässrigen Suspensionen werden die Mischungen derjeweiligen Komponenten mit Hilfe eines Dispergiergeräts (Umdrehungsgeschwindigkeiten bis zu 1m/s) und, falls notwendig, unter Verwendung von Mahlkörpern, gemischt. Der Prozess der Durchmischung kann dabei mindestens 12 Stunden dauern.

Anschließend wird eine Schicht 2 der ersten wässrigen Suspension auf ein Substrat 1, vorzugsweise ein Graphit-Substrat, z.B. ein iso-Graphit-Substrat, aufgebracht. Das Aufbringen erfolgt mittels Sprühauftragung, wobei eine Schicht 2 der ersten wässrigen Suspension mit einer mittleren Schichtdicke im Bereich von 20 bis 80 µm aufgebracht wird. Alternativ kann das Aufbringen z.B. auch mittels Tauchen oder Pinseln erfolgen.

Im Anschluss wird eine Schicht 3 der zweiten wässrigen Suspension auf einem Abschnitt der auf dem Substrat aufgebrachten Schicht 2 der ersten wässrigen Suspension aufgebracht. Das Aufbringen erfolgt auch hier mittels Sprühauftragung, wobei eine Schicht 3 der zweiten wässrigen Suspension mit einer mittleren Schichtdicke im Bereich von 20 bis 80 µm aufgebracht wird. Alternativ kann das Aufbringen auch hier z.B. mittels Tauchen oder Pinseln erfolgen.

Nach dem Aufbringen der beiden Schichten 2, 3 wird das beschichtete Substrat einem Sinterprozess unter Argon-Atmosphäre bei einer Temperatur von 2300 °C, einer Haltezeit von 3 h und einem Druck von 5 bar unterzogen. Da das Sintern aller aufgebrachten Schichten in einem Sinterdurchgang erfolgt, versintern alle einzeln aufgetragenen Schichtlagen miteinander, was zu einem Schichtsystem mit stabilen Anbindungen auch bei hohen thermischen Spannungen führt. Die aus der Schicht 2 der ersten wässrigen Suspension resultierende erste gesinterte Schicht 4 weist aufgrund der Verwendung des Sinteradditivs eine hohe relative Dichte von über 70 % auf. Die aus der Schicht 3 der zweiten wässrigen Suspension resultierende zweite gesinterte Schicht 5 weist eine geringere relative Dichte und damit eine höhere Porosität auf als die erste gesinterte Schicht 4, da in der zweiten wässrigen Suspension kein Sinteradditiv enthalten ist.

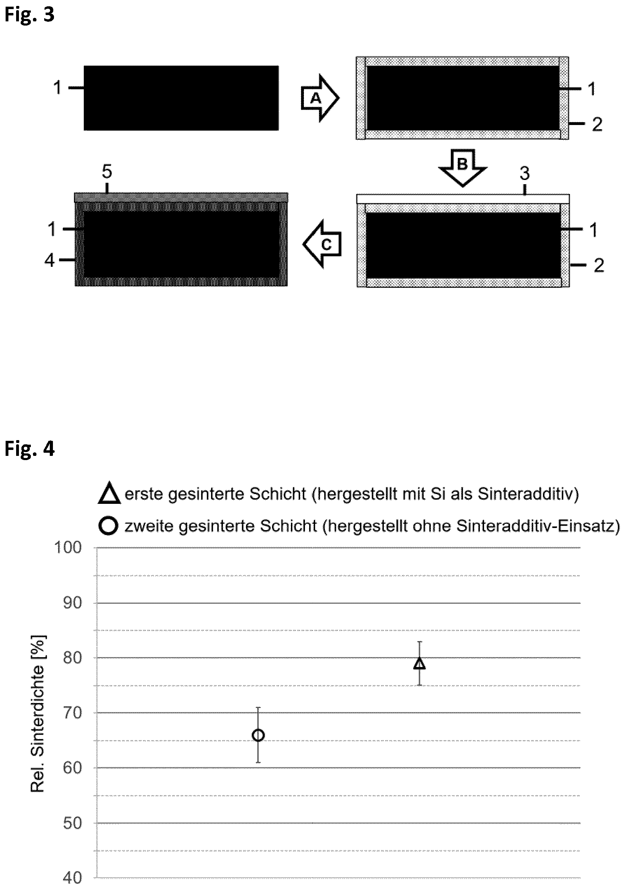

Eine schematische Übersicht der nach der Herstellung der wässrigen Suspensionen durchgeführten Verfahrensschritte ist in Fig. 3 dargestellt.

Im hergestellten gesinterten Substrat weist die erste gesinterte Schicht 4 eine Permeabilität von weniger als 1 e⁻¹³ m² auf, bestimmt über einen Aufbau zur Messung eines Gasvolumenstroms durch die Probe in Abhängigkeit eines Druckunterschieds durch die Probe und die Umrechnung in Darcy's Permeabilitätskonstante. Die Haftfestigkeit, bestimmt über Zugversuche, der ersten gesinterten Schicht 4 beträgt mehr als 4 MPa. Zudem weist die erste gesintert Schicht 4 eine mittlere Schichtdicke von 25 µm bis 30 µm, bestimmt über Querschliffsanalyse, auf.

Anhand der Bestimmung der geometrischen Dichte über die Masse und das Volumen der verdichteten Schichten kann zudem ein Vergleich des Verdichtungsgrads der ersten gesinterten Schicht 4 (resultierend aus der ersten wässrigen Suspension mit 1 Gew.-% Sinteradditiv Silicium) und der zweiten gesinterten Schicht 5 (resultierend aus der zweiten wässrigen Suspension ohne Sinteradditiv) vorgenommen werden. Die Quantifizierung der Erhöhung des Verdichtungsgrads wird auf die relative Dichte bezogen (Verhältnis zwischen geometrischer Dichte und theoretischer Dichte von TaC mit einem Wert von 14,5 g/cm³). Das Ergebnis des Vergleichs ist in Fig. 4 dargestellt, wobei dort die relative Dichte der ersten gesinterten Schicht 4 mit einem Dreieck und die relative Dichte der zweiten gesinterten Schicht 5 mit einem Kreis dargestellt ist. Aus Fig. 4 geht hervor, dass die erste gesinterte Schicht 4 eine relative Dichte von über 70 % aufweist und zudem eine deutlich höhere relative Dichte aufweist als die zweite gesinterte Schicht 5. Hierdurch wird belegt, dass durch die Verwendung von Silicium als Sinteradditiv ein höherer Verdichtungsgrad in der gesinterten Schicht erreicht wird.

### Ausführungsbeispiel 2

Zunächst wurden eine erste wässrige Suspension bestehend aus 80 Gew.-% Tantalcarbid, 1 Gew.-% Molybdänsilicid (MoSi₂) als Sinteradditiv und 19 Gew.-% Wasser sowie eine zweite wässrige Suspension bestehend aus 80 Gew.-% Tantalcarbid und 20 Gew.-% Wasser hergestellt. Die zweite wässrige Suspension enthält somit kein Sinteradditiv. Die mittlere Pulverpartikelgröße der TaC-Partikel liegt vorzugsweise im Bereich zwischen 0,2 und 2 µm. Zur Herstellung der wässrigen Suspensionen werden die Mischungen der jeweiligen Komponenten mit Hilfe eines Dispergiergeräts (Umdrehungsgeschwindigkeiten bis zu 1m/s) und, falls notwendig, unter Verwendung von Mahlkörpern, gemischt. Der Prozess der Durchmischung kann dabei mindestens 12 Stunden dauern.

Anschließend wird eine Schicht 2 der ersten wässrigen Suspension auf ein Substrat 1, vorzugsweise ein Graphit-Substrat, z.B. ein iso-Graphit-Substrat, aufgebracht. Das Aufbringen erfolgt mittels Sprühauftragung, wobei eine Schicht 2 der ersten wässrigen Suspension mit einer mittleren Schichtdicke im Bereich von 20 bis 80 µm aufgebracht wird. Alternativ kann das Aufbringen z.B. auch mittels Tauchen oder Pinseln erfolgen.

Im Anschluss wird eine Schicht 3 der zweiten wässrigen Suspension auf einem Abschnitt der auf dem Substrat aufgebrachten Schicht 2 der ersten wässrigen Suspension aufgebracht. Das Aufbringen erfolgt auch hier mittels Sprühauftragung, wobei eine Schicht 3 der zweiten wässrigen Suspension mit einer mittleren Schichtdicke im Bereich von 20 bis 80 µm aufgebracht wird. Alternativ kann das Aufbringen auch hier z.B. mittels Tauchen oder Pinseln erfolgen.

Nach dem Aufbringen der beiden Schichten 2, 3 wird das beschichtete Substrat einem Sinterprozess unter Argon-Atmosphäre bei einer Temperatur von 2300 °C, einer Haltezeit von 3 h und einem Druck von 5 bar unterzogen. Da das Sintern aller aufgebrachten Schichten in einem Sinterdurchgang erfolgt, versintern alle einzeln aufgetragenen Schichtlagen miteinander, was zu einem Schichtsystem mit stabilen Anbindungen auch bei hohen thermischen Spannungen führt. Die aus der Schicht 2 der ersten wässrigen Suspension resultierende erste gesinterte Schicht 4 weist aufgrund der Verwendung des Sinteradditivs eine hohe relative Dichte von mindestens 70 % auf. Die aus der Schicht 3 der zweiten wässrigen Suspension resultierende zweite gesinterte Schicht 5 weist eine geringere relative Dichte und damit eine höhere Porosität auf als die erste gesinterte Schicht 4, da in der zweiten wässrigen Suspension kein Sinteradditiv enthalten ist.

Eine schematische Übersicht der nach der Herstellung der wässrigen Suspensionen durchgeführten Verfahrensschritte ist in Fig. 3 dargestellt.

Im hergestellten beschichteten Substrat weist die erste gesinterte Schicht 4 eine Permeabilität von weniger als 1 e⁻¹³ m² auf, bestimmt über einen Aufbau zur Messung eines Gasvolumenstroms durch die Probe in Abhängigkeit eines Druckunterschieds durch die Probe und die Umrechnung in Darcy's Permeabilitätskonstante. Die Haftfestigkeit, bestimmt über Zugversuche, der ersten gesinterten Schicht 4 beträgt mehr als 4 MPa. Zudem weist die erste gesinterte Schicht 4 in eine mittlere Schichtdicke von 45 µm bis 50 µm, bestimmt über Querschliffsanalyse, auf.

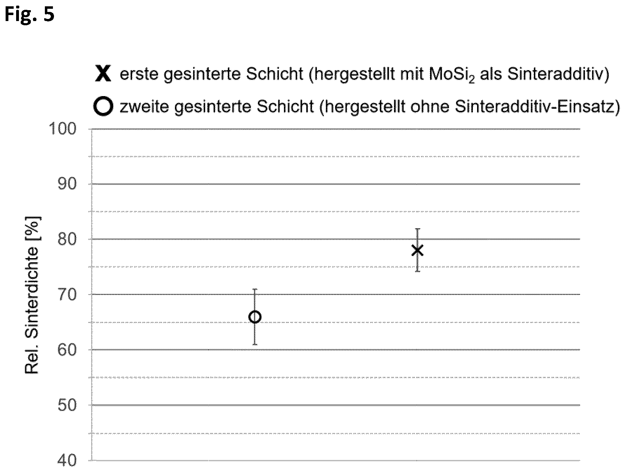

Anhand der Bestimmung der geometrischen Dichte über die Masse und das Volumen der verdichteten Schichten kann im Folgenden ein Vergleich des Verdichtungsgrads der ersten gesinterten Schicht 4 (resultierend aus der ersten wässrigen Suspension mit 1 Gew.-% Sinteradditiv MoSi₂) und der zweiten gesinterten Schicht 5 (resultierend aus der zweiten wässrigen Suspension ohne Sinteradditiv) vorgenommen werden. Die Quantifizierung der Erhöhung des Verdichtungsgrads wird auf die relative Dichte bezogen (Verhältnis zwischen geometrischer Dichte und theoretischer Dichte von TaC mit einem Wert von 14,5 g/cm³). Das Ergebnis des Vergleichs ist in Fig. 5 dargestellt, wobei dort die relative Dichte der ersten gesinterten Schicht 4 mit einem Kreuz und die relative Dichte der zweiten gesinterten Schicht 5 mit einem Kreis dargestellt ist. Aus Fig. 5 geht hervor, dass die relative Dichte der ersten gesinterten Schicht 4 mehr als 70 % beträgt. Zudem weist die erste gesinterte Schicht eine deutlich höhere relative Dichte auf als die zweite gesinterte Schicht 5. Hierdurch wird belegt, dass durch die Verwendung von MOSi₂ als Sinteradditiv ein höherer Verdichtungsgrad in der gesinterten Schicht erreicht wird.

## Patentansprüche

1. Verfahren zur Herstellung von beschichteten Substraten, bei welchem
a) eine erste wässrige Suspension hergestellt wird, die mindestens ein Refraktärmetallcarbid, mindestens ein Sinteradditiv ausgewählt ist aus der Gruppe bestehend aus Silicium, Zirconiumborid, Refraktärmetallsiliciden sowie Mischungen hiervon, und Wasser enthält oder daraus besteht,
b) eine zweite wässrige Suspension hergestellt wird, die mindestens ein Refraktärmetallcarbid und Wasser enthält, wobei die zweite wässrige Suspension
- mindestens ein Sinteradditiv ausgewählt aus der Gruppe bestehend aus Silicium, Zirconiumborid, Refraktärmetallsiliciden sowie Mischungen hiervon enthält, wobei der gewichtsprozentuale Anteil des mindestens einen Sinteradditivs in der zweiten wässrigen Suspension, bezogen auf das Gesamtgewicht der zweiten wässrigen Suspension, kleiner ist als der gewichtsprozentuale Anteil des mindestens einen Sinteradditivs in der ersten wässrigen Suspension, bezogen auf das Gesamtgewicht der ersten wässrigen Suspension, oder
- kein Sinteradditiv enthält,
c) mindestens eine Schicht (2) der ersten wässrigen Suspension auf ein Substrat (1) aufgebracht wird,
d) mindestens eine Schicht (3) der zweiten wässrigen Suspension auf der mindestens einen auf das Substrat (1) aufgebrachten Schicht (2) der ersten wässrigen Suspension aufgebracht wird, und
e) das Substrat (1) nach Schritt d) einem Sinterprozess unterzogen wird.

2. Verfahren nach dem vorhergehenden Anspruch, **dadurch gekennzeichnet, dass**
- das Substrat ein Material enthält oder aus diesem besteht, welches ausgewählt ist aus der Gruppe bestehend aus Graphit, bevorzugt iso-Graphit, kohlenfaserverstärktem Kohlenstoff (CFC), C/SiC-Faserverbundwerkstoffen, SiC/SiC-Faserverbundwerkstoffen, carbidischen Keramiken, nitridischen Keramiken, oxidischen Keramiken, und Mischungen hiervon, und/oder
- die Refraktärmetallsilicide ausgewählt sind aus der Gruppe bestehend aus Titansiliciden, Zirconiumsiliciden, Hafniumsiliciden, Vanadiumsiliciden, Niobsiliciden, Tantalsiliciden, Chromsiliciden, Molybdänsiliciden, Wolframsiliciden, und Mischungen hiervon, und/oder
- das mindestens eine Refraktärmetallcarbid ausgewählt ist aus der Gruppe bestehend aus Titancarbiden, Zirconiumcarbiden, Hafniumcarbiden, Vanadiumcarbiden, Niobcarbiden, Tantalcarbiden, Chromcarbiden, Molybdäncarbiden, Wolframcarbiden, und Mischungen hiervon.

3. Verfahren nach einem der vorhergehenden Ansprüche, **dadurch gekennzeichnet, dass**
- das mindestens eine Refraktärmetallcarbid und das mindestens eine Sinteradditiv jeweils partikulär vorliegen, wobei die mittlere Partikelgröße der Partikel des mindestens einen Sinteradditivs weniger als 5 µm beträgt und/oder kleiner ist als die mittlere Partikelgröße der Partikel des mindestens einen Refraktärmetallcarbids, und/oder
- das mindestens eine Refraktärmetallcarbid als Pulvermischung vorliegt, die sich in der mittleren Partikelgröße der Partikel unterscheidende Pulver, vorzugsweise des gleichen Refraktärmetallcarbids, enthält oder daraus besteht.

4. Verfahren nach einem der vorhergehenden Ansprüche, **dadurch gekennzeichnet, dass** die erste wässrige Suspension und/oder die zweite wässrige Suspension
- 60 bis 90 Gew.-%, bevorzugt 70 bis 85 Gew.-%, des mindestens einen Refraktärmetallcarbids, bezogen auf das Gesamtgewicht der jeweiligen wässrigen Suspension, enthält, und/oder
- 0,1 bis 20 Gew.-%, bevorzugt 0,5 bis 10 Gew.-%, des mindestens einen Sinteradditivs, bezogen auf das Gesamtgewicht der jeweiligen wässrigen Suspension, enthält.

5. Verfahren nach einem der vorhergehenden Ansprüche, **dadurch gekennzeichnet, dass** der gewichtsprozentuale Anteil des mindestens einen Sinteradditivs in der zweiten wässrigen Suspension, bezogen auf das Gesamtgewicht der zweiten wässrigen Suspension, um 0,1 Gew.-% bis 20 Gew.-%, bevorzugt um 0,5 Gew.-% bis 10 Gew.-%, kleiner ist als der gewichtsprozentuale Anteil des mindestens einen Sinteradditivs in der ersten wässrigen Suspension, bezogen auf das Gesamtgewicht der ersten wässrigen Suspension.

6. Verfahren nach einem der vorhergehenden Ansprüche, **dadurch gekennzeichnet, dass** die Herstellung der ersten wässrigen Suspension in Schritt a) und/oder die Herstellung der zweiten wässrigen Suspension in Schritt b) durch Vermischen der Komponenten der herzustellenden Suspension mithilfe eines Dispergiergeräts erfolgt, wobei das Vermischen mithilfe des Dispergiergeräts vorzugsweise unter Verwendung von Mahlkörpern und/oder über einen Zeitraum von mindestens 12 Stunden erfolgt.

7. Verfahren nach einem der vorhergehenden Ansprüche, **dadurch gekennzeichnet, dass** das Aufbringen der mindestens einen Schicht (2) der ersten wässrigen Suspension in Schritt c) und/oder das Aufbringen der mindestens einen Schicht (3) der zweiten wässrigen Suspension in Schritt d)
- mittels Tauchen, Pinseln oder Sprühauftragung erfolgt, und/oder
- mit einer mittleren Schichtdicke von weniger als 150 µm, bevorzugt von 20 µm bis 100 µm, besonders bevorzugt von 30 µm bis 80 µm, erfolgt.

8. Verfahren nach einem der vorhergehenden Ansprüche, **dadurch gekennzeichnet, dass**
zusätzlich mindestens eine dritte wässrige Suspension hergestellt wird, die mindestens ein Refraktärmetallcarbid und Wasser enthält oder daraus besteht, wobei die mindestens eine dritte wässrige Suspension kein Sinteradditiv enthält, und
zwischen Schritt d) und e) mindestens eine Schicht der mindestens einen dritten wässrigen Suspension auf die mindestens eine aufgebrachte Schicht (3) der zweiten wässrigen Suspension aufgebracht wird.

9. Verfahren nach einem der vorhergehenden Ansprüche, **dadurch gekennzeichnet, dass** der Sinterprozess in Schritt e)
- bei einer Temperatur von 2100 °C bis 2500 °C, bevorzugt von 2200 °C bis 2400 °C, erfolgt, und/oder
- mit einer Haltezeit von 1h bis 15 h, bevorzugt von 2 h bis 10 h, erfolgt, und/oder
- bei einem Druck von 0,1 bar bis 10 bar, bevorzugt 0,7 bar bis 5 bar, erfolgt, und/oder
- so erfolgt, dass nach einem ersten zeitlichen Abschnitt des Sinterprozesses der Druck erhöht wird, bevorzugt um 3 bar bis 7 bar, und/oder
- unter Argon-Atmosphäre erfolgt.

10. Beschichtetes Substrat, umfassend ein Substrat (1), mindestens eine auf dem Substrat (1) angeordnete erste gesinterte Schicht (4), die mindestens ein Refraktärmetallcarbid und mindestens ein Sinteradditiv ausgewählt aus der Gruppe bestehend aus Silicium, Zirconiumborid, Refraktärmetallsiliciden und Mischungen hiervon, enthält oder daraus besteht, und mindestens eine auf der mindestens einen ersten gesinterten Schicht (4) angeordnete zweite gesinterte Schicht (5), die mindestens ein Refraktärmetallcarbid und optional mindestens ein Sinteradditiv ausgewählt aus der Gruppe bestehend aus Silicium, Zirconiumborid, Refraktärmetallsiliciden und Mischungen hiervon, enthält oder daraus besteht, wobei die mindestens eine erste gesinterte Schicht (4) eine relative Dichte von mindestens 70 % aufweist, und wobei die relative Dichte der mindestens einen zweiten gesinterten Schicht (5) um mindestens 3 % geringer ist als die relative Dichte der mindestens einen ersten gesinterten Schicht (4).

11. Beschichtetes Substrat nach Anspruch 10, **dadurch gekennzeichnet, dass** die mindestens eine erste gesinterte Schicht (4)
- eine relative Dichte von mehr als 75 %, bevorzugt von mehr als 80 %, besonders bevorzugt von mehr als 90 %, ganz besonders bevorzugt von mehr als 95 % aufweist, und/oder
- eine Permeabilität von weniger als 1 e⁻¹¹ m², bevorzugt von weniger als 1 e⁻¹³ m², aufweist, und/oder
- eine Haftfestigkeit von mindestens 2 MPa, bevorzugt von mindestens 4 MPa, aufweist, und/oder
- eine mittlere Schichtdicke von mindestens 20 µm, bevorzugt von 20 µm bis 150 µm, besonders bevorzugt von 30 µm bis 100 µm, aufweist.

12. Beschichtetes Substrat nach Anspruch 10 oder 11, **dadurch gekennzeichnet, dass** die mindestens eine zweite gesinterte Schicht (5)
- eine relative Dichte aufweist, die mindestens 5 %, bevorzugt mindestens 10 %, besonders bevorzugt 10 % bis 30 %, ganz besonders bevorzugt 15 % bis 25 %, insbesondere 18 % bis 22 %, geringer ist als die relative Dichte der mindestens einen ersten gesinterten Schicht, und/oder
- eine Permeabilität von weniger als 1 e⁻¹¹ m², bevorzugt von weniger als 1 e⁻¹² m², aufweist, und/oder
- eine Haftfestigkeit von mindestens 2 MPa, bevorzugt von mindestens 4 MPa, aufweist, und/oder
- eine mittlere Schichtdicke von mindestens 20 µm, bevorzugt von 20 µm bis 150 µm, besonders bevorzugt von 30 µm bis 100 µm, aufweist.

13. Beschichtetes Substrat nach einem der Ansprüche 10 bis 12, **dadurch gekennzeichnet, dass** das beschichtete Substrat mindestens eine auf der mindestens einen zweiten gesinterten Schicht (5) angeordnete dritte gesinterte Schicht umfasst, die mindestens ein Refraktärmetallcarbid enthält oder daraus besteht, wobei die mindestens eine dritte gesinterte Schicht kein Sinteradditiv enthält, und wobei die relative Dichte der mindestens einen dritten gesinterten Schicht um mindestens 5 % geringer ist als die relative Dichte der mindestens einen zweiten gesinterten Schicht (5),
wobei vorzugsweise die mindestens eine dritte gesinterte Schicht eine Schichtfolge mehrerer gesinterter Schichten umfasst, wobei die relative Dichte der mehreren gesinterten Schichten innerhalb der Schichtfolge mit zunehmendem Abstand zur mindestens einen zweiten gesinterten Schicht (5) abnimmt.

14. Beschichtetes Substrat nach einem der Ansprüche 10 bis 13, **dadurch gekennzeichnet, dass** das beschichtete Substrat mit einem Verfahren gemäß einem der Ansprüche 1 bis 9 herstellbar oder hergestellt ist.

15. Verwendung eines beschichteten Substrats nach einem der Ansprüche 10 bis 14 in der Halbleiterkristallzüchtung, wobei es sich bei dem beschichteten Substrat vorzugsweise um einen beschichteten Tiegel handelt.

## Geänderte Patentansprüche

### Geänderte Patentansprüche gemäss Regel 137(2) EPÜ.

1. Verfahren zur Herstellung von beschichteten Substraten, bei welchem
a) eine erste wässrige Suspension hergestellt wird, die mindestens ein Refraktärmetallcarbid, mindestens ein Sinteradditiv ausgewählt ist aus der Gruppe bestehend aus Silicium, Zirconiumborid, Refraktärmetallsiliciden sowie Mischungen hiervon, und Wasser enthält oder daraus besteht,
b) eine zweite wässrige Suspension hergestellt wird, die mindestens ein Refraktärmetallcarbid und Wasser enthält, wobei die zweite wässrige Suspension
- mindestens ein Sinteradditiv ausgewählt aus der Gruppe bestehend aus Silicium, Zirconiumborid, Refraktärmetallsiliciden sowie Mischungen hiervon enthält, wobei der gewichtsprozentuale Anteil des mindestens einen Sinteradditivs in der zweiten wässrigen Suspension, bezogen auf das Gesamtgewicht der zweiten wässrigen Suspension, kleiner ist als der gewichtsprozentuale Anteil des mindestens einen Sinteradditivs in der ersten wässrigen Suspension, bezogen auf das Gesamtgewicht der ersten wässrigen Suspension, oder
- kein Sinteradditiv enthält,
c) mindestens eine Schicht (2) der ersten wässrigen Suspension auf ein Substrat (1) aufgebracht wird,
d) mindestens eine Schicht (3) der zweiten wässrigen Suspension auf der mindestens einen auf das Substrat (1) aufgebrachten Schicht (2) der ersten wässrigen Suspension aufgebracht wird, und
e) das Substrat (1) nach Schritt d) einem Sinterprozess unterzogen wird.

2. Verfahren nach dem vorhergehenden Anspruch, **dadurch gekennzeichnet, dass**
- das Substrat ein Material enthält oder aus diesem besteht, welches ausgewählt ist aus der Gruppe bestehend aus Graphit, bevorzugt iso-Graphit, kohlenfaserverstärktem Kohlenstoff (CFC), C/SiC-Faserverbundwerkstoffen, SiC/SiC-Faserverbundwerkstoffen, carbidischen Keramiken, nitridischen Keramiken, oxidischen Keramiken, und Mischungen hiervon, und/oder
- die Refraktärmetallsilicide ausgewählt sind aus der Gruppe bestehend aus Titansiliciden, Zirconiumsiliciden, Hafniumsiliciden, Vanadiumsiliciden, Niobsiliciden, Tantalsiliciden, Chromsiliciden, Molybdänsiliciden, Wolframsiliciden, und Mischungen hiervon, und/oder
- das mindestens eine Refraktärmetallcarbid ausgewählt ist aus der Gruppe bestehend aus Titancarbiden, Zirconiumcarbiden, Hafniumcarbiden, Vanadiumcarbiden, Niobcarbiden, Tantalcarbiden, Chromcarbiden, Molybdäncarbiden, Wolframcarbiden, und Mischungen hiervon.

3. Verfahren nach einem der vorhergehenden Ansprüche, **dadurch gekennzeichnet, dass**
- das mindestens eine Refraktärmetallcarbid und das mindestens eine Sinteradditiv jeweils partikulär vorliegen, wobei die mittlere Partikelgröße der Partikel des mindestens einen Sinteradditivs weniger als 5 µm beträgt und/oder kleiner ist als die mittlere Partikelgröße der Partikel des mindestens einen Refraktärmetallcarbids, und/oder
- das mindestens eine Refraktärmetallcarbid als Pulvermischung vorliegt, die sich in der mittleren Partikelgröße der Partikel unterscheidende Pulver, vorzugsweise des gleichen Refraktärmetallcarbids, enthält oder daraus besteht.

4. Verfahren nach einem der vorhergehenden Ansprüche, **dadurch gekennzeichnet, dass** die erste wässrige Suspension und/oder die zweite wässrige Suspension
- 60 bis 90 Gew.-%, bevorzugt 70 bis 85 Gew.-%, des mindestens einen Refraktärmetallcarbids, bezogen auf das Gesamtgewicht der jeweiligen wässrigen Suspension, enthält, und/oder
- 0,1 bis 20 Gew.-%, bevorzugt 0,5 bis 10 Gew.-%, des mindestens einen Sinteradditivs, bezogen auf das Gesamtgewicht der jeweiligen wässrigen Suspension, enthält.

5. Verfahren nach einem der vorhergehenden Ansprüche, **dadurch gekennzeichnet, dass** der gewichtsprozentuale Anteil des mindestens einen Sinteradditivs in der zweiten wässrigen Suspension, bezogen auf das Gesamtgewicht der zweiten wässrigen Suspension, um 0,1 Gew.-% bis 20 Gew.-%, bevorzugt um 0,5 Gew.-% bis 10 Gew.-%, kleiner ist als der gewichtsprozentuale Anteil des mindestens einen Sinteradditivs in der ersten wässrigen Suspension, bezogen auf das Gesamtgewicht der ersten wässrigen Suspension.

6. Verfahren nach einem der vorhergehenden Ansprüche, **dadurch gekennzeichnet, dass** die Herstellung der ersten wässrigen Suspension in Schritt a) und/oder die Herstellung der zweiten wässrigen Suspension in Schritt b) durch Vermischen der Komponenten der herzustellenden Suspension mithilfe eines Dispergiergeräts erfolgt, wobei das Vermischen mithilfe des Dispergiergeräts vorzugsweise unter Verwendung von Mahlkörpern und/oder über einen Zeitraum von mindestens 12 Stunden erfolgt.

7. Verfahren nach einem der vorhergehenden Ansprüche, **dadurch gekennzeichnet, dass** das Aufbringen der mindestens einen Schicht (2) der ersten wässrigen Suspension in Schritt c) und/oder das Aufbringen der mindestens einen Schicht (3) der zweiten wässrigen Suspension in Schritt d)
- mittels Tauchen, Pinseln oder Sprühauftragung erfolgt, und/oder
- mit einer mittleren Schichtdicke von weniger als 150 µm, bevorzugt von 20 µm bis 100 µm, besonders bevorzugt von 30 µm bis 80 µm, erfolgt.

8. Verfahren nach einem der vorhergehenden Ansprüche, **dadurch gekennzeichnet, dass**
zusätzlich mindestens eine dritte wässrige Suspension hergestellt wird, die mindestens ein Refraktärmetallcarbid und Wasser enthält oder daraus besteht, wobei die mindestens eine dritte wässrige Suspension kein Sinteradditiv enthält, und
zwischen Schritt d) und e) mindestens eine Schicht der mindestens einen dritten wässrigen Suspension auf die mindestens eine aufgebrachte Schicht (3) der zweiten wässrigen Suspension aufgebracht wird.

9. Verfahren nach einem der vorhergehenden Ansprüche, **dadurch gekennzeichnet, dass** der Sinterprozess in Schritt e)
- bei einer Temperatur von 2100 °C bis 2500 °C, bevorzugt von 2200 °C bis 2400 °C, erfolgt, und/oder
- mit einer Haltezeit von 1 h bis 15 h, bevorzugt von 2 h bis 10 h, erfolgt, und/oder
- bei einem Druck von 0,1 bar bis 10 bar, bevorzugt 0,7 bar bis 5 bar, erfolgt, und/oder
- so erfolgt, dass nach einem ersten zeitlichen Abschnitt des Sinterprozesses der Druck erhöht wird, bevorzugt um 3 bar bis 7 bar, und/oder
- unter Argon-Atmosphäre erfolgt.

10. Beschichtetes Substrat, umfassend ein Substrat (1), mindestens eine auf dem Substrat (1) angeordnete erste gesinterte Schicht (4), die mindestens ein Refraktärmetallcarbid und mindestens ein Sinteradditiv ausgewählt aus der Gruppe bestehend aus Silicium, Zirconiumborid, Refraktärmetallsiliciden und Mischungen hiervon, enthält oder daraus besteht, und mindestens eine auf der mindestens einen ersten gesinterten Schicht (4) angeordnete zweite gesinterte Schicht (5), die mindestens ein Refraktärmetallcarbid und optional mindestens ein Sinteradditiv ausgewählt aus der Gruppe bestehend aus Silicium, Zirconiumborid, Refraktärmetallsiliciden und Mischungen hiervon, enthält oder daraus besteht, wobei die mindestens eine erste gesinterte Schicht (4) eine relative Dichte von mindestens 70 % aufweist, und wobei die relative Dichte der mindestens einen zweiten gesinterten Schicht (5) um mindestens 3 % geringer ist als die relative Dichte der mindestens einen ersten gesinterten Schicht (4).

11. Beschichtetes Substrat nach Anspruch 10, **dadurch gekennzeichnet, dass** die mindestens eine erste gesinterte Schicht (4)
- eine relative Dichte von mehr als 75 %, bevorzugt von mehr als 80 %, besonders bevorzugt von mehr als 90 %, ganz besonders bevorzugt von mehr als 95 % aufweist, und/oder
- eine mittlere Schichtdicke von mindestens 20 µm, bevorzugt von 20 µm bis 150 µm, besonders bevorzugt von 30 µm bis 100 µm, aufweist.

12. Beschichtetes Substrat nach Anspruch 10 oder 11, **dadurch gekennzeichnet, dass** die mindestens eine zweite gesinterte Schicht (5)
- eine relative Dichte aufweist, die mindestens 5 %, bevorzugt mindestens 10 %, besonders bevorzugt 10 % bis 30 %, ganz besonders bevorzugt 15 % bis 25 %, insbesondere 18 % bis 22 %, geringer ist als die relative Dichte der mindestens einen ersten gesinterten Schicht, und/oder
- eine mittlere Schichtdicke von mindestens 20 µm, bevorzugt von 20 µm bis 150 µm, besonders bevorzugt von 30 µm bis 100 µm, aufweist.

13. Beschichtetes Substrat nach einem der Ansprüche 10 bis 12, **dadurch gekennzeichnet, dass** das beschichtete Substrat mindestens eine auf der mindestens einen zweiten gesinterten Schicht (5) angeordnete dritte gesinterte Schicht umfasst, die mindestens ein Refraktärmetallcarbid enthält oder daraus besteht, wobei die mindestens eine dritte gesinterte Schicht kein Sinteradditiv enthält, und wobei die relative Dichte der mindestens einen dritten gesinterten Schicht um mindestens 5 % geringer ist als die relative Dichte der mindestens einen zweiten gesinterten Schicht (5),
wobei vorzugsweise die mindestens eine dritte gesinterte Schicht eine Schichtfolge mehrerer gesinterter Schichten umfasst, wobei die relative Dichte der mehreren gesinterten Schichten innerhalb der Schichtfolge mit zunehmendem Abstand zur mindestens einen zweiten gesinterten Schicht (5) abnimmt.

14. Beschichtetes Substrat nach einem der Ansprüche 10 bis 13, **dadurch gekennzeichnet, dass** das beschichtete Substrat mit einem Verfahren gemäß einem der Ansprüche 1 bis 9 herstellbar oder hergestellt ist.

15. Verwendung eines beschichteten Substrats nach einem der Ansprüche 10 bis 14 in der Halbleiterkristallzüchtung, wobei es sich bei dem beschichteten Substrat vorzugsweise um einen beschichteten Tiegel handelt.
